# EUROPEAN PATENT APPLICATION

(11) **EP 4 636 769 A1**
(43) Date of publication of application: **22.10.2025**
(21) Application number: 25162667.7
(22) Date of filing: 10.03.2025
(51) Int. Cl.: G11C 29/00, G11C 29/02, G11C 29/44

(54) **LOGIC DIE FOR PERFORMING THROUGH SILICON VIA REPAIR OPERATION AND SEMICONDUCTOR DEVICE INCLUDING THE LOGIC DIE**

(30) Priority: 17.04.2024 KR 20240051617; 18.06.2024 KR 20240079093
(71) Applicant: Samsung Electronics Co., Ltd., Suwon-si, Gyeonggi-do 16677 (KR)
(72) Inventor: BAE, Changyoung, 16677 Suwon-si (KR); KIM, Dongha, 16677 Suwon-si (KR); OH, Jihun, 16677 Suwon-si (KR); CHAE, Kwanyeob, 16677 Suwon-si (KR)
(74) Representative: Marks & Clerk LLP

(57) **Abstract**

A logic die for performing a through silicon via (TSV) repair operation and a semiconductor device including the logic die are provided. The semiconductor device includes the logic die including a memory controller and an interface circuit, a plurality of core dies stacked in a vertical direction on the logic die, each of the plurality of core dies including a memory cell array, and a plurality of through silicon vias (TSVs) configured to electrically connect the logic die to the plurality of core dies, the plurality of TSVs including a plurality of operation TSVs and at least one redundancy TSV. The interface circuit includes a plurality of TSV circuit blocks electrically connected to the plurality of TSVs, respectively, and a TSV repair logic configured to perform a repair operation on a first TSV, in which a defect occurs and a first TSV circuit block, electrically connected to the first TSV.

## Description

### BACKGROUND

One or more example embodiments of the disclosure relate to a semiconductor device, and more particularly, to a logic die for performing a through silicon via (TSV) repair operation and a semiconductor device including the logic die.

As an example of semiconductor devices, a dynamic random-access memory (DRAM) is a volatile memory in which data is determined based on an electric charge stored in a capacitor. As an example of a DRAM, a high bandwidth memory (HBM) which provides an input/output based on a multichannel interface is applied to various systems such as graphics, servers, supercomputers, and networks, which need high performance and low power. An HBM may include a base die and core dies which are stacked on the base die in a vertical direction, and the base die may be connected to the core dies through a plurality of TSVs. Generally, communication via an interposer is needed for interfacing between a memory controller of an external die and core dies of the HBM, and due to this, latency may increase when transmitting or receiving a signal.

### SUMMARY

One or more example embodiments of the disclosure provide a logic die for efficiently performing a through silicon via (TSV) repair operation and a semiconductor device including the logic die.

A semiconductor device according to one or more example embodiments includes a logic die including a memory controller and an interface circuit, a plurality of core dies stacked in a vertical direction on the logic die, each of the plurality of core dies including a memory cell array, and a plurality of through silicon vias (TSVs) configured to electrically connect the logic die to the plurality of core dies, the plurality of TSVs including a plurality of operation TSVs and at least one redundancy TSV, wherein the interface circuit includes a plurality of TSV circuit blocks provided in a TSV region of the logic die and electrically connected to the plurality of TSVs, respectively, and a TSV repair logic configured to perform a repair operation on a first TSV, in which a defect occurs, among the plurality of operation TSVs and a first TSV circuit block, electrically connected to the first TSV, among the plurality of TSV circuit blocks.

A semiconductor device according to one or more example embodiments includes a logic die including a memory controller, an interface circuit, and a plurality of through silicon vias (TSVs) and a plurality of core dies stacked on the logic die in a vertical direction and electrically connected to the logic die through the plurality of TSVs, each of the plurality of core dies including a memory cell array, wherein the interface circuit includes a plurality of TSV circuit blocks provided in a TSV region of the logic die and electrically connected to the plurality of TSVs, respectively, and a TSV repair logic configured to change a transmission path of a first signal, corresponding to a first TSV, in which a defect occurs, among the plurality of TSVs, from a first TSV circuit block to a second TSV circuit block, and wherein the second TSV circuit block includes a phase shift logic configured to change a synchronization clock phase corresponding to the first signal.

A logic die according to one or more example embodiments includes a memory controller, a plurality of through silicon vias (TSVs) including a plurality of operation TSVs and at least one redundancy TSV, the plurality of TSVs being provided in a TSV region, and an interface circuit between the memory controller and the plurality of TSVs, wherein the interface circuit includes a plurality of TSV macros arranged in an array form in the TSV region and electrically connected to the plurality of TSVs, and a TSV repair logic configured to perform a repair operation on a first TSV, in which a defect occurs, among the plurality of operation TSVs and a first TSV macro, electrically connected to the first TSV, among the plurality of TSV macros.

A "macro" may be a functional block of circuitry. A "hard macro" may have a predefined physical layout (e.g. wiring pattern). Accordingly, multiple instances of the same hard macro may be circuits having the same function and same physical layout (e.g. wiring pattern).

At least some of the above and other features of the invention are set out in the claims.

### BRIEF DESCRIPTION OF DRAWINGS

Example embodiments will be more clearly understood from the following detailed description taken in conjunction with the accompanying drawings in which:
FIG. 1 is a block diagram illustrating a semiconductor device according to one or more example embodiments;
FIG. 2 is a diagram schematically illustrating a structure of a semiconductor device according to one or more example embodiments;
FIG. 3A is a diagram illustrating a high bandwidth memory (HBM) system according to a comparative example, and FIG. 3B is a diagram illustrating an HBM device according to one or more example embodiments;
FIG. 4 is a block diagram illustrating a semiconductor device according to one or more example embodiments;
FIG. 5 is a diagram schematically illustrating a through silicon via (TSV) repair operation according to one or more example embodiments;
FIGS. 6A and 6B are diagrams illustrating a logic die according to example embodiments;
FIGS. 7A to 7C are diagrams illustrating a TSV macro array according to example embodiments;
FIG. 8 is a flowchart illustrating a TSV repair operation method according to one or more example embodiments;
FIGS. 9A and 9B are diagrams illustrating a boundary scan (BSCAN) test operation according to one or more example embodiments;
FIGS. 10 and 11 are diagrams illustrating a TSV repair operation according to example embodiments;
FIG. 12 is a diagram illustrating a TSV repair logic and TSV macros according to one or more example embodiments;
FIGS. 13 and 14 are diagrams illustrating a plurality of lanes according to example embodiments;
FIG. 15 is a diagram schematically illustrating a TSV repair operation when transmitting write data, according to one or more example embodiments;
FIG. 16 is a diagram schematically illustrating a TSV repair operation when transmitting read data, according to one or more example embodiments;
FIG. 17 is a block diagram schematically illustrating a TSV macro according to one or more example embodiments;
FIG. 18 is a block diagram illustrating a TSV macro according to one or more example embodiments;
FIG. 19 is a timing diagram illustrating a data transmission operation based on the TSV macro of FIG. 18, according to one or more example embodiments;
FIG. 20 is a block diagram illustrating a TSV macro according to one or more example embodiments;
FIG. 21 is a block diagram illustrating a TSV macro according to one or more example embodiments;
FIG. 22 is a timing diagram illustrating a signal transmission operation based on the TSV macro of FIG. 21, according to one or more example embodiments;
FIG. 23 is a diagram schematically illustrating a TSV repair operation when transmitting a signal, according to one or more example embodiments;
FIG. 24 is a diagram illustrating an HBM semiconductor device according to one or more example embodiments;
FIGS. 25A and 25B are diagrams illustrating an HBM semiconductor device according to example embodiments; and
FIGS. 26A and 26B are diagrams illustrating an electronic system including an HBM semiconductor device according to one or more example embodiments.

### DETAILED DESCRIPTION

Hereinafter, example embodiments will be described in detail with reference to the accompanying drawings. Like reference numerals refer to like elements in the drawings, and their repeated descriptions are omitted. As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

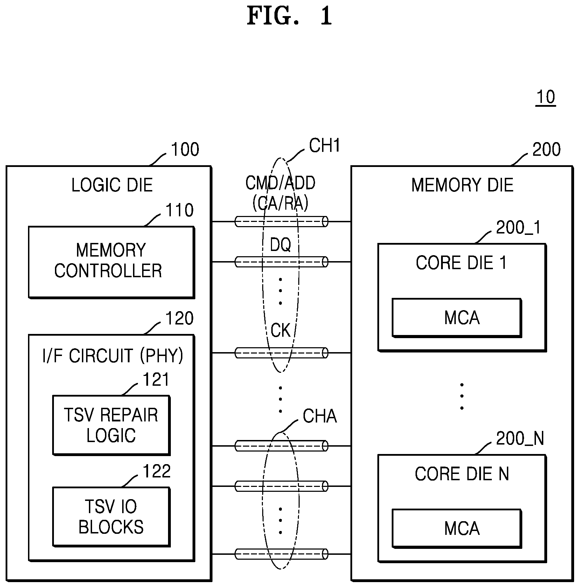

FIG. 1 is a block diagram illustrating a semiconductor device 10 according to one or more example embodiments.

Referring to FIG. 1, the semiconductor device 10 may include a logic die 100 and a memory die 200. According to one or more example embodiments, the semiconductor device 10 may be referred to as a memory device, a memory system, a storage device, or a storage system. According to one or more example embodiments, the logic die 100 may be referred to as a logic chip, a base die, a controller, a controller chip, a controller die, or a host. According to one or more example embodiments, the memory die 200 may be referred to as a memory chip or a core die. For example, the memory die 200 may include a plurality of core dies 200_1 to 200_N (where N may be a natural number of 2 or greater) or a plurality of memory dies each including a memory cell array (MCA). The number of core dies included in the memory die 200 may be variously changed according to embodiments.

The logic die 100 may include a memory controller 110 and an interface circuit 120. The memory controller 110 may control an overall operation of the memory die 200 as well as a write operation and a read operation on the memory die 200. The interface circuit 120 may perform interfacing between the memory controller 110 and the memory die 200. According to one or more example embodiments, the interface circuit 120 may be referred to as a memory interface or a memory interface circuit. For example, the interface circuit 120 may correspond to a physical circuit PHY.

The logic die 100 may transmit at least one of a command CMD, an address ADDR, and a clock signal CK to the memory die 200 through the interface circuit 120. For example, the command/address CMD/ADDR may include a column address CA and a row address RA, namely, a column/row address CA/RA. Also, the logic die 100 may transmit data DQ (e.g., write data) to the memory die 200 through the interface circuit 120, and/or may receive the data DQ (e.g., read data) from the memory die 200 through the interface circuit 120.

In one or more example embodiments, the logic die 100 and the plurality of core dies 200_1 to 200_N may communicate with each other through a plurality of through silicon vias (TSVs), and the interface circuit 120 may include a TSV repair logic 121 and a plurality of TSV input/output (I/O) blocks 122. Each of the plurality of TSV I/O blocks 122 may be connected to at least one TSV, and may include at least one circuit in order to process a signal transmitted or received through the connected at least one TSV. Therefore, the TSV I/O blocks 122 may be referred to as "TSV circuit blocks".

In one or more example embodiments, the TSV repair logic 121 may perform a repair operation or a remapping operation on a defective TSV, where a defect occurs, of the plurality of TSVs and a TSV I/O block, connected to the defective TSV, of the TSV I/O blocks 122. For example, the TSV repair logic 121 may change or remap a transmission path of a first signal corresponding to a first TSV, in response to a control signal or a repair information signal indicating a defect of the first TSV.

In detail, the TSV repair logic 121 may perform a TSV repair operation or a TSV remapping operation of changing or remapping a TSV, through which the first signal is to be transmitted, from the first TSV in which a defect occurs to a second TSV. Also, the TSV repair logic 121 may perform a TSV circuit block repair operation or a TSV circuit block remapping operation of changing or remapping a TSV circuit block, through which the first signal corresponding to the first TSV is to be transmitted, from a first TSV circuit block to a second TSV circuit block. For example, the second TSV may correspond to a redundancy TSV or a TSV adjacent to the first TSV. For example, the first TSV circuit block may be connected to the first TSV, and the second TSV circuit block may be connected to the second TSV or the redundancy TSV.

In one or more example embodiments, the TSV repair logic 121 may perform a repair operation (e.g., a TSV I/O block repair operation) on a defective TSV I/O block of the plurality of TSV I/O blocks 122. In detail, the TSV repair logic 121 may change or remap a transmission path of the first signal corresponding to the first TSV I/O block, in response to a control signal indicating a defect of the first TSV I/O block. For example, the TSV repair logic 121 may change the TSV circuit block, through which the first signal is to be transmitted, from the first TSV circuit block to the second TSV circuit block. In this case, the first TSV circuit block may be a defective TSV I/O block, and the second TSV circuit block may be a redundancy TSV I/O block or a TSV I/O block adjacent to the first TSV circuit block.

In one or more example embodiments, the TSV repair logic 121 may include a plurality of TSV repair logics which are implemented by repair units. For example, a repair unit may correspond to a lane or a set. For example, the TSV repair logic 121 may include a plurality of TSV repair logics which are implemented by lanes. Here, a "lane" or "set" may be defined as including a plurality of TSV circuit blocks respectively connected to a plurality of operation TSVs and at least one redundancy TSV circuit block connected to at least one redundancy TSV. In this case, a repair unit or a lane may be changed based on physical positions of TSVs and/or physical positions of TSV circuit blocks.

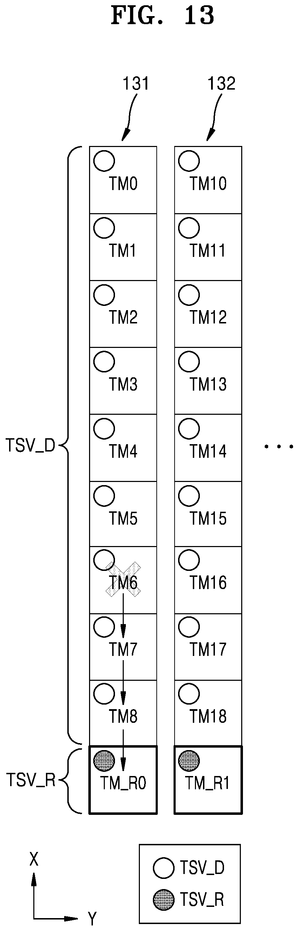

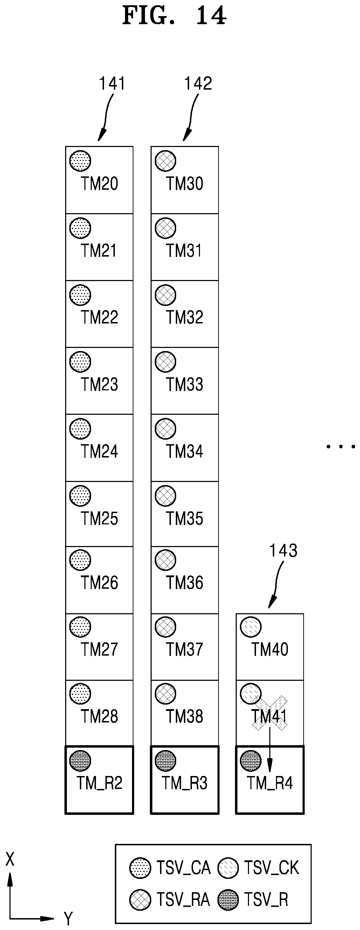

In one or more example embodiments, the TSV repair logic 121 may perform a TSV repair operation on TSVs physically adjacent to a defective TSV and/or physically adjacent to each other, and may perform a TSV I/O block repair operation on TSV I/O blocks physically adjacent to a defective TSV I/O block and/or physically adjacent to each other. For example, the TSV repair logic 121 may perform a TSV repair operation on ten TSVs physically adjacent to each other. This will be described in more detail with reference to FIGS. 13 and 14. As described above, a TSV repair unit may be changed based on a physical position of a TSV, and thus, an efficiency of a TSV repair operation may be enhanced.

For example, the TSV repair logic 121 may perform a TSV repair operation on the data DQ, the column address CA, the row address RA, and the clock signal CK. For example, the TSV repair logic 121 may perform a TSV repair operation on an error correction code (ECC) signal, a severity signal SEV for checking whether an error occurs in a bit transmitted from the memory die 200 to the logic die 100, a controller clock CLK, a memory clock CLK_MEM, a memory write clock WCK, a memory read clock BRCK, a read clock CRCK, and/or a stack identification (ID) SID.

In one or more example embodiments, the semiconductor device 10 may be provided as a high bandwidth memory (HBM). In this case, the semiconductor device 10 may provide a wide interface architecture based on a multichannel interface between the logic die 100 and the memory die 200. For example, N (the number of core dies) may be 4, and each of the plurality of core dies 200_1 to 200_N may support a 4-channel interface, and thus, the memory die 200 may support a 16-channel interface. However, the disclosure is not limited thereto, and each of the plurality of core dies 200_1 to 200_N may support a 1-channel interface, a 2-channel interface, a 4-channel interface, or more. An HBM may comply with a joint electron device engineering council (JEDEC) standard, such as HBM2, HBM2E, HBM3, HBM3E, HBM4, or later.

In one or more example embodiments, the logic die 100 and the plurality of core dies 200_1 to 200_N may communicate with each other through TSVs and/or through backside vias (TBVs). Moreover, each of the plurality of core dies 200_1 to 200_N (where N may be a natural number of 2 or greater) may include a plurality of channels which independently communicate with the logic die 100, and TSVs and/or TBVs may be disposed to be physically differentiated from a plurality of channels. For example, in a case where the memory die 200 includes a first channel CH1 to an Ath (where A may be a natural number of 2 or greater) channel CHA and each of the plurality of core dies 200_1 to 200_N includes two channels, A number of channels may correspond to 2×N number of channels. Also, in a case where each of the plurality of core dies 200_1 to 200_N includes four channels, A number of channels may correspond to 4×N number of channels.

According to one or more example embodiments, the TSV I/O blocks 122 may be implemented as macros or hard macros and may be electrically connected to a plurality of TSVs. A macro may refer to a reusable functional block or module that performs a specific function within an integrated circuit. A hard macro may refer to a fixed-layout functional block (e.g. a functional block that has a pre-defined physical design, such as a predefined wiring pattern). The hard macros may specify a fixed wiring pattern and may be, for example, an area in which an analog circuit block is formed. The hard macros may be various intellectual properties (IPs). IP may denote blocks which are reusable and are implemented to include an interconnection and a layout designed to perform a desired electrical function. Therefore, the TSV I/O block or the TSV circuit block may be referred to as a "TSV macro" or a "TSV slice". Hereinafter, the TSV I/O block or the TSV circuit block may be referred to as a "TSV macro".

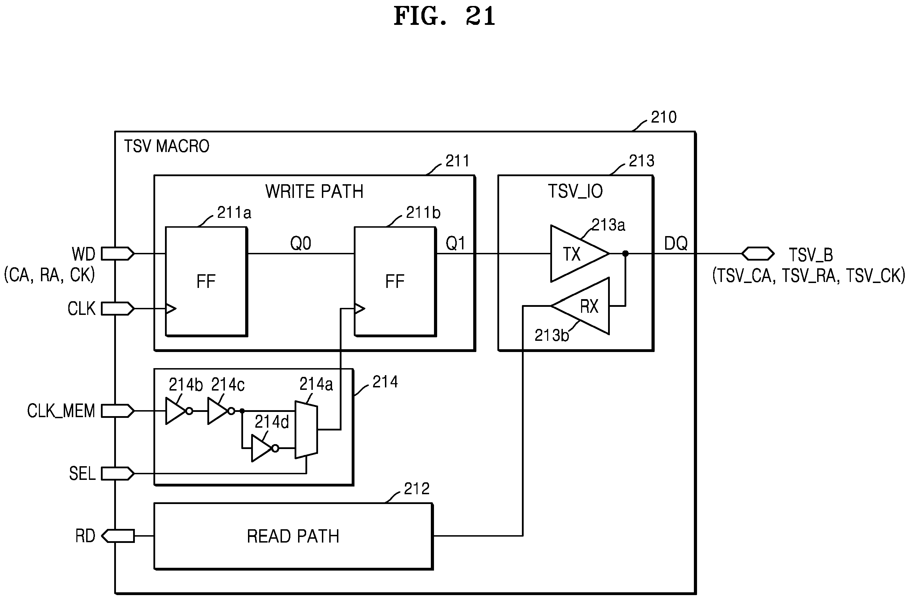

In one or more example embodiments, in a TSV repair operation corresponding to signal TSVs through which the column address CA, the row address RA, and/or the clock signal CA are transmitted, a synchronization clock phase may be changed in a repair TSV macro or a redundancy TSV macro, based on a synchronization clock phase of a signal corresponding to a defective TSV. For example, the clock signal CK may include a memory clock CLK_MEM, a memory write clock WCK, a memory read clock BRCK, and a read clock CRCK. Accordingly, a TSV repair operation may be adaptively performed on a signal transmitted through a signal TSV. This will be described in more detail with reference to FIGS. 21 to 23.

In one or more example embodiments, the memory controller 110 of the logic die 100 may operate in a first voltage domain, and the memory die 200 may operate in a second voltage domain. The interface circuit 120 or each TSV macro may change a signal level of a transmission signal (for example, the data DQ, the column address CA, the row address RA, and/or the clock signal CK), transmitted from the memory controller 110 to the memory die 200, from a first voltage level based on the first voltage domain to a second voltage level based on the second voltage domain. The interface circuit 120 or each TSV macro may change a signal level of a reception signal (for example, the data DQ and/or the clock signal CK), transmitted from the memory die 200 to the memory controller 110, from the second voltage level based on the second voltage domain to the first voltage level based on the first voltage domain.

In one or more example embodiments, the memory controller 110 of the logic die 100 may operate in a first clock domain, and the memory die 200 may operate in a second clock domain. In detail, an internal signal of the logic die 100 (e.g., a signal transmitted to and/or received from the memory controller 110 within the logic die 100) may be synchronized with a controller clock based on the first clock domain. Also, an internal signal of the memory die 200 (e.g., a signal transmitted or received in the memory die 200) may be synchronized with a memory clock based on the second clock domain. The interface circuit 120 or each TSV macro may synchronize the transmission signal, to be transmitted from the memory controller 110 to the memory die 200, with the memory clock and may transmit the transmission signal, synchronized with the memory clock, to the memory die 200. Also, the interface circuit 120 or each TSV macro may synchronize a reception signal, transmitted from the memory die 200 to the memory controller 110, with a controller clock and may transmit the reception signal, synchronized with the controller clock, to the memory controller 110.

According to embodiments, each TSV macro may process data and/or a signal transmitted or received between the memory controller 110 and the memory die 200 through a corresponding TSV to support direct interfacing between the memory controller 110 and the memory die 200 through the TSV. Also, a plurality of TSV macros respectively connected to a plurality of TSVs may be arranged in an array form, thereby decreasing a difficulty level of design of a memory interface. Furthermore, a TSV macro may be selectively disposed based on a signal and data transmitted and received through a TSV, and thus, the degree of freedom of a memory interface may increase. Also, the number of TSVs corresponding to each TSV macro may be changed, and thus, the interface circuit 120 may be freely designed based on a size of the logic die 100 or an available area of the interface circuit 120 in the logic die 100.

Moreover, according to embodiments, the TSV I/O blocks 122 may respectively correspond to TSVs, and thus, the TSV repair logic 121 may perform a TSV repair operation and a TSV I/O block repair operation at a time. In detail, the TSV repair logic 121 may bypass a defective TSV and a TSV I/O block connected to the defective TSV through remapping of a signal transmission path at a time. Accordingly, latency and power consumption may be reduced when transmitting or receiving a signal.

The semiconductor device 10 may be implemented to be included in, for example but not limited to, a personal computer (PC), a mobile electronic device, and/or a data server. The mobile electronic device may be implemented as, for example but not limited to, a laptop computer, a mobile phone, a smartphone, a tablet PC, a personal digital assistant (PDA), an enterprise digital assistant (EDA), a digital still camera, a digital video camera, a portable multimedia player (PMP), a personal navigation device (or portable navigation device) (PND), a handheld game console, a mobile Internet device (MID), a wearable computer, an Internet of things (IoT) device, an Internet of everything (IoE) device, and/or a drone.

The logic die 100 may include an application specific integrated circuit (ASIC), a system-on-chip (SoC), an application processor (AP), a mobile AP, and/or a chipset, or may be a device corresponding thereto. Also, the logic die 100 may further include at least one of various elements, configured to perform a function as a host, such as a central processing unit (CPU), a graphics processing unit (GPU), a neural processing unit (NPU), an accelerated processing unit (APU), a tensor processing unit (TPU), a field programmable gate array (FPGA), a massively parallel processor array (MPPA), and/or a multi-processor system-on-chip (MPSoC), etc.

The memory controller 110 may access the memory die 200 in response to a request from the host and may communicate with the host by using various protocols. For example, the memory controller 110 may communicate with the host by using an interface protocol such as peripheral component interconnection (PCI) express (PIC-E), advanced technology attachment (ATA), serial-ATA (SATA), parallel-ATA (PATA), and/or small computer system interface (SCSI). In addition, other various interface protocols such as a universal serial bus (USB), a multimedia card (MMC), an enhanced small disk interface (ESDI), and/or integrated drive electronics (IDE) may be applied to protocols between the host and the memory controller 110.

The memory cell array MCA included in each of the plurality of core dies 200_1 to 200_N may include DRAM cells, and in this case, the semiconductor device 10 may be referred to as an HBM DRAM or an HBM. For example, the memory cell array MCA may include a double data rate synchronous dynamic random access memory (DDR SDRAM), a low power double data rate (LPDDR) SDRAM, a graphics double data rate (GDDR) SDRAM, or a Rambus dynamic random access memory (RDRAM). However, the disclosure is not limited thereto, and the memory cell array MCA may include a volatile memory, such as a static random access memory (RAM) (SRAM), or a non-volatile memory such as a magnetic RAM, a ferroelectric RAM (FeRAM), a phase change RAM (PRAM), or a resistive RAM (ReRAM).

Also, each of the plurality of core dies 200_1 to 200_N may further include a peripheral circuit configured to control a write operation and a read operation on the memory cell array MCA. In one or more example embodiments, each of the plurality of core dies 200_1 to 200_N may further include a computational circuit configured to perform computational processing by using data received from the logic die 100.

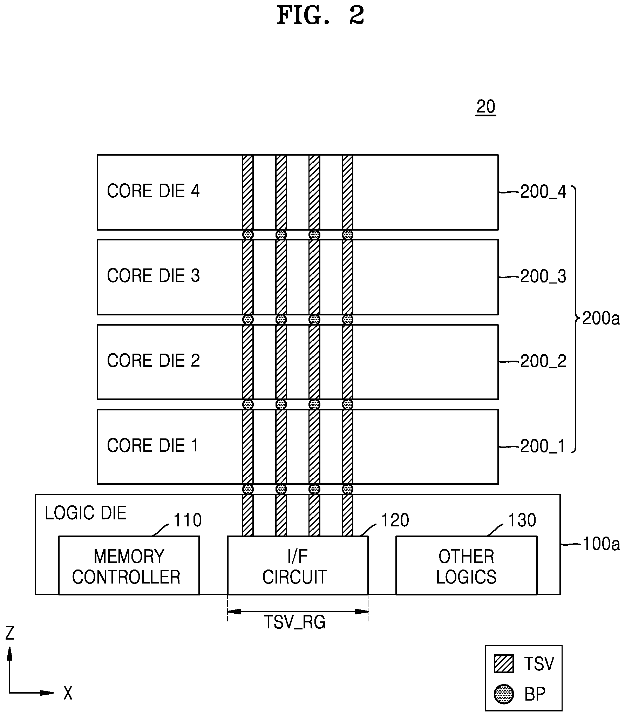

FIG. 2 is a diagram schematically illustrating a structure of a semiconductor device 20 according to one or more example embodiments.

Referring to FIG. 2, the semiconductor device 20 may include a logic die 100a and a memory die 200a, and the memory die 200a may include a plurality of core dies 200_1 to 200_4 which are stacked in a vertical direction Z on the logic die 100a. According to one or more example embodiments, the semiconductor device 20 may be referred to as a three-dimensional (3D) memory device or a stack-type memory device. For example, the semiconductor device 20 may correspond to a 3D HBM. The semiconductor device 20 may correspond to an implementation example of the semiconductor device 10 of FIG. 1, and the descriptions described above with reference to FIG. 1 may be applied to the embodiment of FIG. 2.

Each of the logic die 100a and the core dies 200_1 to 200_4 may include TSVs. The TSVs of the logic die 100a may pass through the logic die 100a and may extend in the vertical direction Z, and the TSVs of each of the core dies 200_1 to 200_4 may pass through a corresponding core die of the core dies 200_1 to 200_4 and may extend in the vertical direction Z. The vertical direction Z may be a direction in which the core dies are stacked. The vertical direction Z may be perpendicular to a substrate of each of one or more of dies (e.g. one or more of the logic die 100a and the core dies 200_1 to 200_4). A first direction X may be defined perpendicular to the vertical direction Z. A second direction Y may be defined perpendicular to the first direction X and the vertical direction Z. The first direction X and the second direction Y may be "horizontal directions". It will be appreciated that the terms "vertical" and "horizontal" are relative to the structure of the device, and need not imply any particular orientation of the device in use. The "vertical direction" may be otherwise known as a "third direction" or "stack direction". Bumps BP may be disposed between the logic die 100a and the core dies (for example, first to fourth core dies) 200_1 to 200_4. For example, each of the bumps BP may be a micro-bump. For example, each of the bumps BP may be a conductive bump including copper, cobalt, or nickel. The logic die 100a and the core dies 200_1 to 200_4 may be electrically connected to each other through the TSVs and the bumps BP.

The logic die 100a may further include a memory controller 110 and an interface circuit 120. The TSVs of the logic die 100a may be disposed in a TSV region TSV_RG, and the interface circuit 120 may be disposed to be connected to the TSVs in the TSV region TSV_RG. For example, the interface circuit 120 may be disposed under the TSVs in the TSV region TSV_RG, and thus, the interface circuit 120 may be electrically connected to the first to fourth core dies 200_1 to 200_4 through the TSVs.

The interface circuit 120 may include a plurality of TSV macros (for example, 122 of FIG. 1) and a TSV repair logic (for example, 121 of FIG. 1). Each of the plurality of TSV macros may be connected to at least one TSV and may process a signal or data transmitted and received through the connected at least one TSV, and thus, may perform an I/O operation through a corresponding TSV. For example, each TSV may change a voltage level of a signal or data, to be transmitted through a connected TSV, to a voltage level based on a voltage domain of a die to which the signal or data is to be transmitted. For example, each TSV may synchronize a signal or data, to be transmitted through a connected TSV, with a clock based on a clock domain of a die to which the signal or data is to be transmitted.

The logic die 100a may further include other logics 130. For example, the other logics 130 may include a CPU or a GPU. For example, the other logics 130 may include interface logics. In FIG. 2, it is illustrated that the memory controller 110, the interface circuit 120, and the other logics 130 are arranged in a first direction X, but the disclosure is not limited thereto. According to one or more example embodiments, the arrangement of the memory controller 110, the interface circuit 120, and the other logics 130 may be variously changed in the logic die 100a.

Also, the logic die 100a may further include backside vias (for example, TBVs). For example, the TBVs may be disposed to be connected to the interface circuit 120 in the TSV region TSV_RG. Therefore, the interface circuit 120 may be electrically connected to the first to fourth core dies 200_1 to 200_4 through the TBVs and/or wirings connected to the TBVs. Also, the interface circuit 120 may be electrically connected to other elements of the logic die 100a (for example, the memory controller 110 and the other logics 130) through the TBVs, or may be connected to an external device.

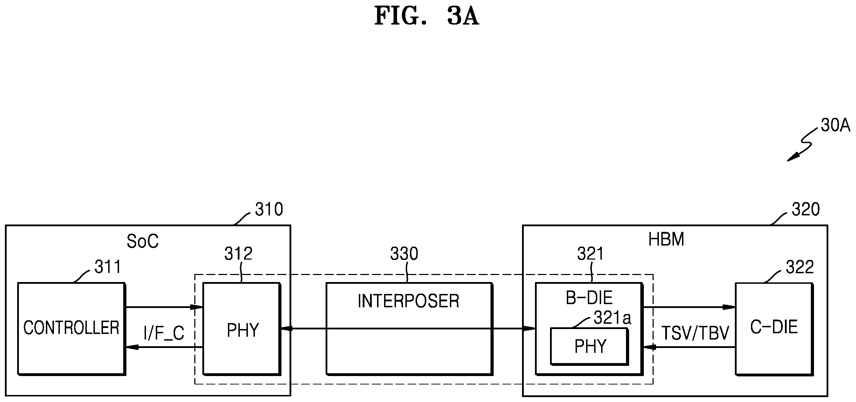

FIG. 3A illustrates an HBM system 30A according to a comparative example.

Referring to FIG. 3A, the HBM system 30A may include an SoC 310 and an HBM 320, and the HBM 320 may include a base die 321 and core dies 322 disposed on the base die 321. The SoC 310 and the HBM 320 may be disposed on an interposer 330, and thus, the HBM 320 may be referred to as a 2.5D HBM or a 2.5D DRAM. The SoC 310 may include a controller 311 and a physical region (PHY) 312, and the controller 311 and the physical region 312 may communicate a command/address and data, based on a controller interface I/F_C such as a DDR PHY interface (DFI). The physical region 312 may communicate with a physical region 321a included in the base die 321 of the HBM 320 through the interposer 330. For example, the SoC 310 and the HBM 320 may communicate a command/address and data through the interposer 330, based on high-speed communication based on a joint electron device engineering council (JEDEC) interface.

When a defect occurs in transmitting data or a signal, the controller 311 of the SoC 310 may detect a defective pin in the physical region 312 of the SoC 310 and the physical region 321a of the HBM 320 and may bypass the detected defective pin to transmit a signal. Also, when a defect occurs in transmitting data or a signal, the controller 311 of the SoC 310 may detect a defective TSV in the base die 321 and the core dies 322 of the HBM 320 and may bypass the detected defective TSV to transmit a signal. As described above, in a case where the controller 311 of the SoC 310 performs an operation of bypassing a defective data transmission path or a defective signal transmission path, latency and power consumption may be very large.

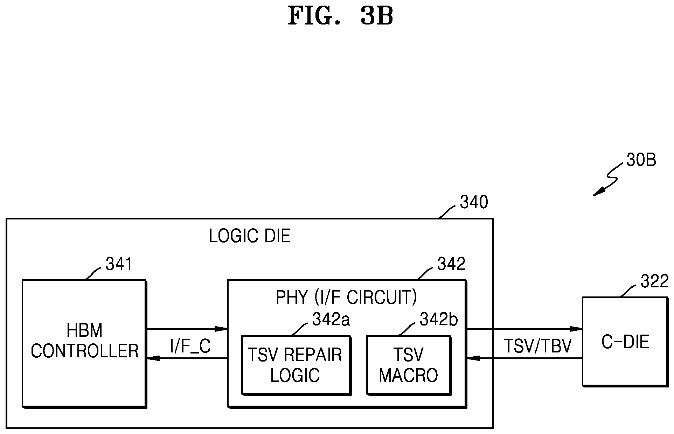

FIG. 3B illustrates an HBM device 30B according to one or more example embodiments.

Referring to FIG. 3B, the HBM device 30B may include a logic die 340 and a plurality of core dies 322. The plurality of core dies 322 may be stacked on the logic die 340, and thus, the HBM device 30B may be referred to as a 3D HBM or a 3D DRAM. For example, the HBM device 30B may correspond to the semiconductor device 10 of FIG. 1 and/or the semiconductor device 20 of FIG. 2, and the descriptions described above with reference to FIGS. 1 and 2 may be applied to the embodiment of FIG. 3B. The logic die 340 may include a controller 341 and a physical region (PHY) 342, and the physical region 342 may be referred to as 3D HBM PHY. The controller 341 and the physical region 342 may communicate a command/address and data, based on a controller interface I/F_C such as a DFI. For example, the controller 341 may correspond to the memory controller 110 of FIG. 1, and the physical region 342 may correspond to the interface circuit 120 of FIG. 1.

According to embodiments, the controller 341 may be disposed in the logic die 340 and may be connected to the core dies 322 through a TSV interface without passing through the physical region 312 of the SoC 310, the interposer 330, and the base die 321 of FIG. 3A. The physical region 342 of the logic die 340 may perform functions of the physical region 312 of the SoC 310, the interposer 330, and the base die 321 of the HBM 320 of FIG. 3A, and thus, an implementation area of the HBM device 30B may be substantially reduced. Also, in a case where the controller 341 transmits a command/address and data to the core dies 322, the controller 341 may not perform communication based on the JEDEC interface through an interposer, and thus, latency and power consumption caused by the transmission of command/address and data may be substantially reduced.

The physical region 342 of the logic die 340 may include a TSV repair logic 342a and TSV macros 342b. In one or more example embodiments, the TSV repair logic 342a may perform a repair operation on a defective TSV of a plurality of TSVs, a defective TBV of a plurality of TBVs, and/or a defective TSV macro of the TSV macros 342b. In one or more example embodiments, the TSV repair logic 342a may perform a repair operation on a TSV macro, connected to a defective TSV, of the TSV macros 342b or a TSV macro connected to a defective TBV, of the TSV macros 342b. For example, the TSV repair logic 342a may correspond to the TSV repair logic 121 of FIG. 1. The TSV macros 342b may support interfacing between the controller 341 and the core dies 322 through TSVs and/or TBVs. For example, the TSV macros 342b may correspond to the TSV I/O blocks 122 of FIG. 1.

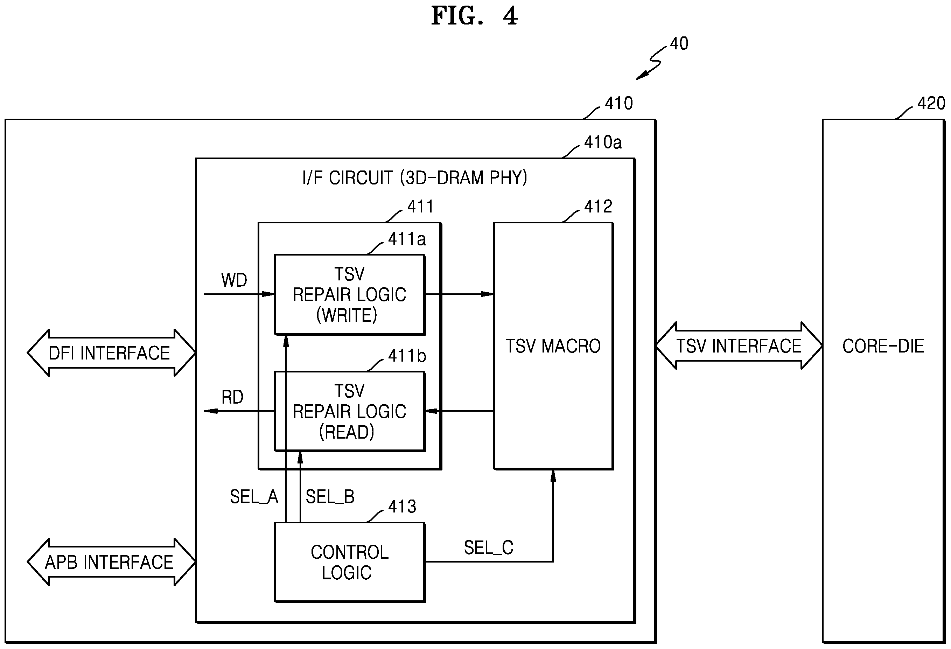

FIG. 4 is a block diagram illustrating a semiconductor device 40 according to one or more example embodiments.

Referring to FIG. 4, the semiconductor device 40 may include a logic die 410 and a core die 420, and the logic die 410 may include an interface circuit 410a. The logic die 410 may correspond to an implementation example of the logic die 100 of FIG. 1 and/or the logic die 100a of FIG. 2, and the core die 420 may be included in a memory die (for example, 200 of FIG. 1 and/or 200a of FIG. 2). According to one or more example embodiments, the interface circuit 410a may be referred to as 3D-DRAM PHY. The logic die 410 and the core die 420 may communicate with each other through a plurality of TSVs, based on a TSV interface.

The interface circuit 410a may include a TSV repair logic 411, a TSV macro 412, and a control logic 413. The TSV repair logic 411 may perform communication through, for example, a DFI interface. For example, the TSV repair logic 411 may communicate with a memory controller (for example, 110 of FIG. 2) through the DFI interface. The TSV macro 412 may communicate with the core die 420 through, for example, the TSV interface. The control logic 413 may perform communication through, for example, an advanced peripheral bus (APB) interface. For example, the control logic 413 may communicate with another logic (for example, 130 of FIG. 2), a host, or a memory controller through the APB interface.

The control logic 413 may control a TSV repair operation, a TSV macro repair operation, and/or a synchronization clock phase, based on repair information about a defective TSV and/or a defective TSV macro. In one or more example embodiments, the control logic 413 may generate control signals SEL_A and SEL_B for changing a transmission path of a signal corresponding to the defective TSV and/or a transmission path of a signal corresponding to the defective TSV macro. In one or more example embodiments, the control logic 413 may generate a control signal SEL_C for changing a synchronization clock phase of a repair TSV macro and/or a redundancy TSV macro. For example, the control logic 413 may generate the control signals SEL_A, SEL_B, and SEL_C, based on special function register (SFR) setting. In one or more example embodiments, the control signals SEL_A and SEL_B may be generated to be equal to each other. In one or more example embodiments, the control signals SEL_A, SEL_B, and SEL_C may be generated to be equal to one another.

The TSV repair logic 411 may include a first TSV repair logic 411a configured to receive write data WD from the memory controller and a second TSV repair logic 411b configured to receive read data RD from the core die 420. In response to the control signal SEL_A, the first TSV repair logic 411a may remap the write data WD corresponding to the defective TSV or the defective TSV macro and may change a transmission path thereof. For example, the write data WD may include data DQ, a column address CA, a row address RA, and/or a clock signal CK. In response to the control signal SEL_B, the second TSV repair logic 411b may remap the read data RD corresponding to the defective TSV and/or the defective TSV macro and may change a reception path thereof. For example, the read data RD may include the data DQ and/or a read clock CRCK.

The TSV macro 412 may perform interfacing between the TSV repair logic 411 and the core die 420. In one or more example embodiments, the TSV macro 412 may synchronize a signal, synchronized with a controller clock, with a memory clock. For example, the memory clock may correspond to one of a plurality of memory clocks having a certain phase difference, and a synchronization clock phase (e.g., a phase of the memory clock) may differ based on a signal input to the TSV macro 412.

For example, the TSV macro 412 may include a phase shift logic (for example, 214 of FIG. 21). The phase shift logic may change a synchronization clock phase corresponding to a signal input to the TSV macro 412 in response to the control signal SEL_C. For example, when a remapped signal is applied to the TSV macro 412, the control signal SEL_C input to the TSV macro 412 may be changed, and in response to the changed control signal SEL_C, the TSV macro 412 may synchronize the remapped signal with a changed synchronization clock phase.

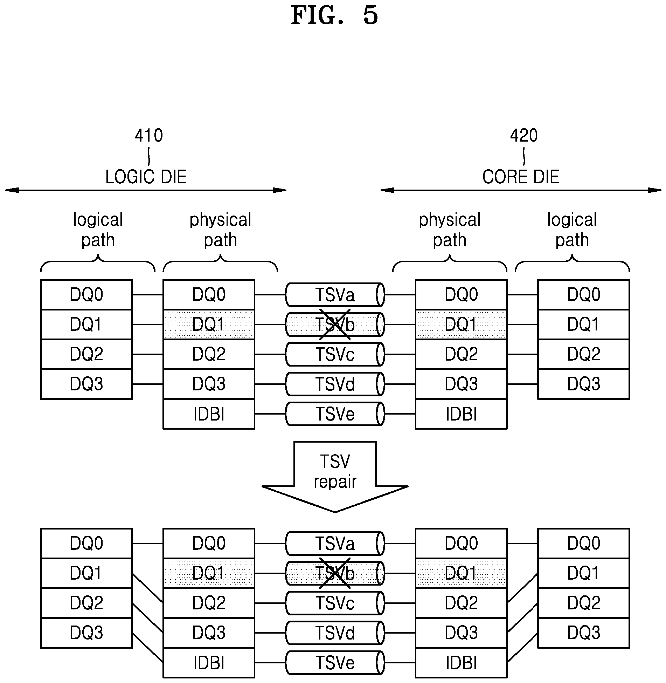

FIG. 5 is a diagram schematically illustrating a TSV repair operation according to one or more example embodiments.

Referring to FIG. 5 in conjunction with FIG. 4, a logic die 410 may be electrically connected to a core die 420 through first to fourth TSVs TSVa to TSVd and a redundancy TSV TSVe. According to one or more example embodiments, the first to fourth TSVs TSVa to TSVd may be referred to as operation TSVs, normal TSVs, or initially (or previously) allocated TSVs. First to fourth data DQ0 to DQ3 may respectively correspond to the first to fourth TSVs TSVa to TSVd. The first to fourth TSVs TSVa to TSVd may be allocated for transmission of the first to fourth data DQ0 to DQ3. Therefore, the first to fourth data DQ0 to DQ3 may be respectively transmitted through the first to fourth TSVs TSVa to TSVd. The redundancy TSV TSVe may be connected to a preliminary signal pin (for example, an IDBI pin), in preparation for a case where a repair operation is performed on the first to fourth TSVs TSVa to TSVd. According to one or more example embodiments, the redundancy TSV TSVe may be referred to as a redundant TSV, a repair TSV, or an initially unallocated TSV. In one or more example embodiments, the redundancy TSV TSVe may include at least one redundancy TSV. That is, while FIG. 5 illustrates one redundancy TSV TSVe, the disclosure is not limited thereto and two or more redundancy TSVs may be included.

When a defect occurs in one of the first to fourth TSVs TSVa to TSVd, the logic die 410 may perform a remapping operation on the first to fourth data DQ0 to DQ3 and may perform a TSV repair operation, based on a remapping operation on the first to fourth data DQ0 to DQ3. Herein, a "TSV repair operation" may denote an operation of transmitting a signal by bypassing a TSV (e.g., a defective TSV) where a defect occurs. For example, when a defect occurs in the second TSV TSVb, the second TSV TSVb may be referred to as a defective TSV. At this time, the logic die 410 may perform a remapping operation on a logical path of one or more of (e.g. each of) the first to fourth data DQ0 to DQ3, and thus, a repair operation of changing a physical path of one or more of (e.g. each of) the first to fourth data DQ0 to DQ3 may be performed. For instance, the logical path for at least the data (the second data DQ1) originally allocated to the defective TSV (the second TSV TSVb) may be remapped. Where data is remapped to an operation TSV, the data previously allocated to that operation TSV that may also be remapped.

In detail, the logic die 410 may change a transmission path of the second data DQ1, corresponding to the second TSV TSVb where a defect occurs, from the second TSV TSVb to the third TSV TSVc. Also, the logic die 410 may change a transmission path of the third data DQ2, corresponding to the third TSV TSVc, from the third TSV TSVc to the fourth TSV TSVd and may change a transmission path of the fourth data DQ3, corresponding to the fourth TSV TSVd, from the fourth TSV TSVd to the redundancy TSV TSVe.

Likewise, the core die 420 may change the transmission path of the second data DQ1, corresponding to the second TSV TSVb where a defect occurs, from the second TSV TSVb to the third TSV TSVc. Also, the core die 420 may change a transmission path of the third data DQ2, corresponding to the third TSV TSVc, from the third TSV TSVc to the fourth TSV TSVd and may change a transmission path of the fourth data DQ3, corresponding to the fourth TSV TSVd, from the fourth TSV TSVd to the redundancy TSV TSVe.

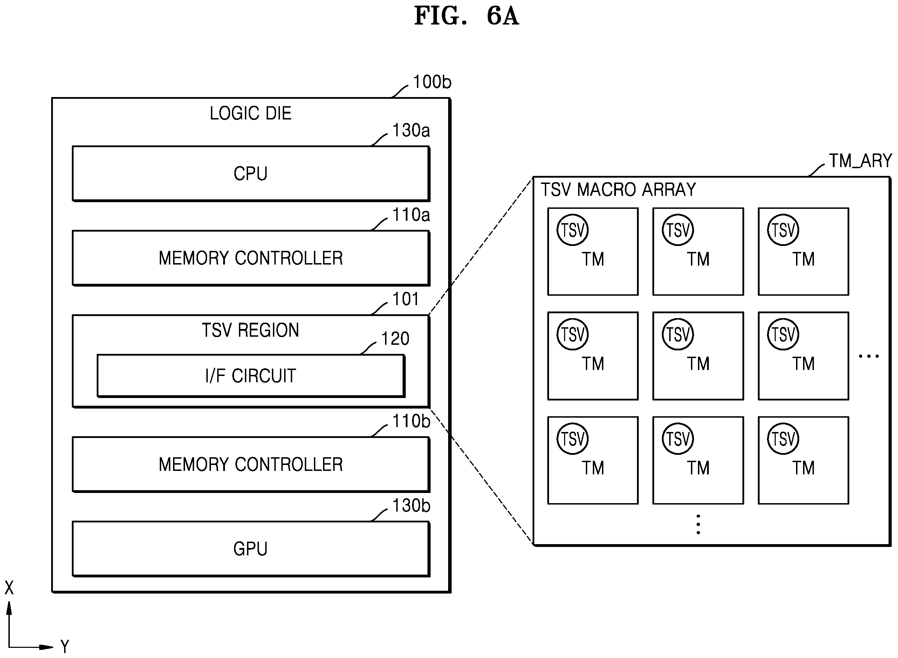

FIG. 6A illustrates a logic die 100b according to one or more example embodiments.

Referring to FIG. 6A, the logic die 100b may include a TSV region 101, memory controllers 110a and 110b, a CPU 130a, and a GPU 130b. In this case, the logic die 100b may correspond to an example of the logic die 100a of FIG. 2, and the TSV region 101 may correspond to the TSV region TSV_RG of FIG. 2. The descriptions of FIGS. 1 and 2 may be applied to the embodiment of FIG. 6A.

The logic die 100b may further include a plurality of TSVs and an interface circuit 120, which are disposed in the TSV region 101, and the interface circuit 120 may include a plurality of TSV macros TM. Each of the plurality of TSV macros TM may be connected to at least one TSV. In FIG. 6A, it is illustrated that each TSV macro TM is connected to one TSV, but the disclosure is not limited thereto. According to one or more example embodiments, each TSV macro TM may be connected to one or more TSVs.

In one or more example embodiments, the interface circuit 120 may include a TSV macro array TM_ARY. For example, the plurality of TSVs may be arranged in an array form in a first direction X and a second direction Y, and the plurality of TSV macros TM may be arranged in an array form in the first direction X and the second direction Y. Accordingly, the plurality of TSV macros TM may configure the TSV macro array TM_ARY.

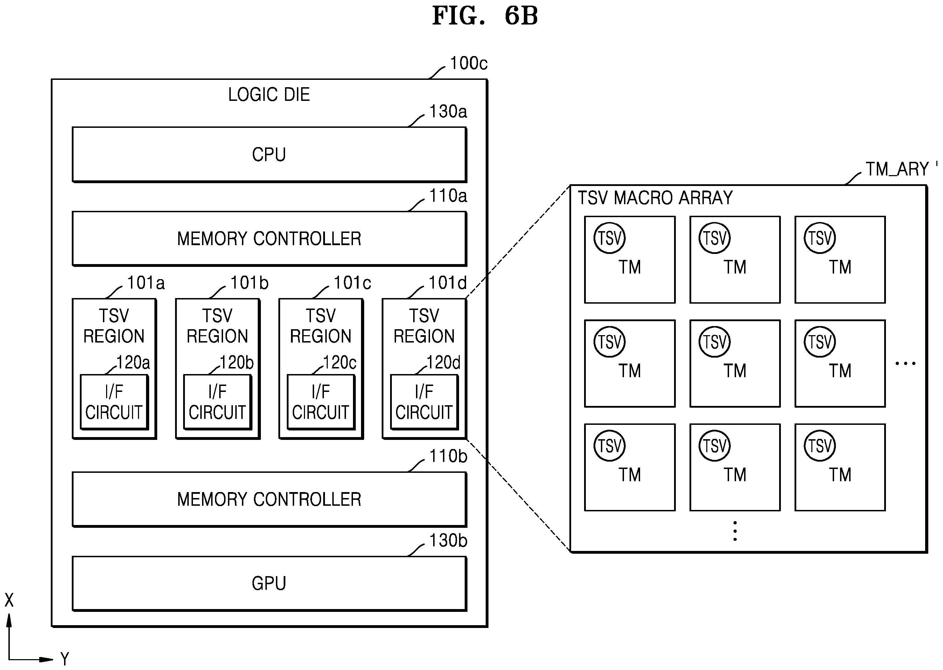

FIG. 6B illustrates a logic die 100c according to one or more example embodiments.

Referring to FIG. 6B, the logic die 100c may correspond to a modified example of the logic die 100b of FIG. 6A. A TSV region TSV_RG of the logic die 100c may include first to fourth TSV regions 101a to 101d. A plurality of TSVs and a plurality of TSV macros TM may be disposed in each of the first to fourth TSV regions 101a to 101d. However, the disclosure is not limited thereto, and the TSV region TSV_RG may be divided into five or more TSV regions, or may be divided into four less TSV regions. That is, the number of TSV regions may be varied.

Each of the first to fourth TSV regions 101a to 101d may correspond to a plurality of channels. For example, each of the first to fourth TSV regions 101a to 101d may correspond to four channels. For example, the first TSV region 101a may include an interface circuit 120a which corresponds to two channels of a first core die (for example, 200_1 of FIG. 2) and two channels of a third core die (for example, 200_3 of FIG. 2). An interface circuit disposed in each of the first to fourth TSV regions 101a to 101d may include a TSV macro array. For example, an interface circuit 120d disposed in the fourth TSV region 101d may include a TSV macro array TM_ARY' where a plurality of TSV macros TM are arranged in an array form.

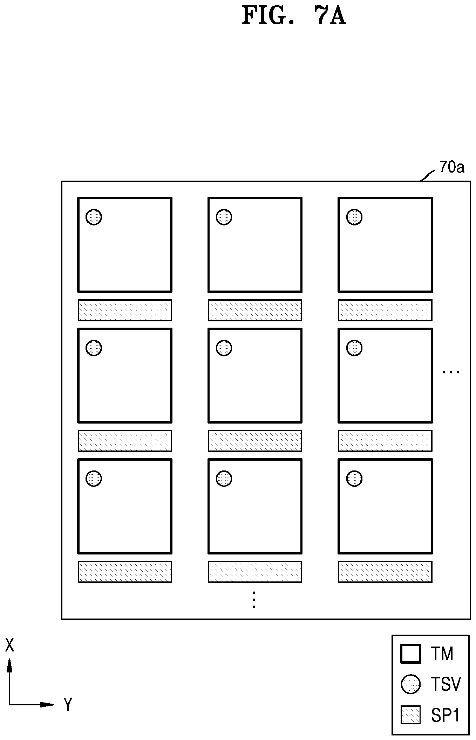

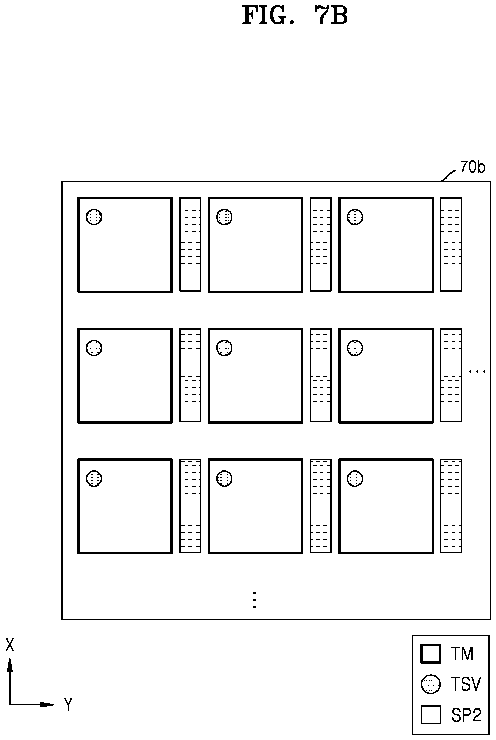

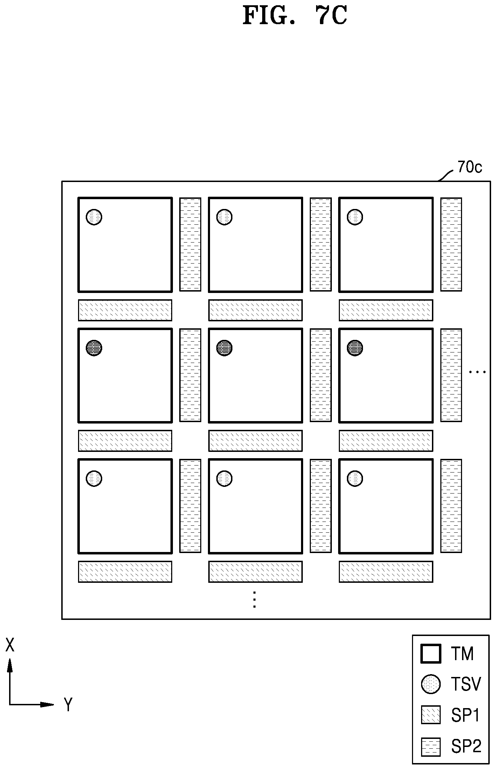

FIGS. 7A to 7C are diagrams illustrating a TSV macro array according to example embodiments.

Referring to FIGS. 7A to 7C, a TSV macro array 70a may include TSV macros TM and first signal processing blocks SP1, and each of the TSV macros TM may be connected to at least one TSV. Each first signal processing block SP1 may be disposed between two (e.g. a corresponding pair of) TSV macros TM adjacent to each other in a first direction X. A TSV macro array 70b may include TSV macros TM and second signal processing blocks SP2, and each of the TSV macros TM may be connected to at least one TSV. Each second signal processing block SP2 may be disposed between two (e.g. a corresponding pair of) TSV macros TM adjacent to each other in a second direction Y. A TSV macro array 70c may include TSV macros TM, first signal processing blocks SP1, and second signal processing blocks SP2, and each of the TSV macros TM may be connected to at least one TSV. Each first signal processing block SP1 may be disposed between two (e.g. a corresponding pair of) TSV macros TM adjacent to each other in the first direction X, and each second signal processing block SP2 may be disposed between two (e.g. a corresponding pair of) TSV macros TM adjacent to each other in the second direction Y.

In one or more example embodiments, the first and second signal processing blocks SP1 and SP2 may be implemented as soft macros. Compared with the hard macros, the soft macros may not specify a wiring pattern, and thus, the soft macros may have flexibility in physical implementation. That is, the first signal processing blocks may have varying wiring patterns and the second signal processing blocks may have varying wiring patterns. Accordingly, the first and second signal processing blocks SP1 and SP2 may be respectively referred to as first and second soft macros. The first and second signal processing blocks SP1 and SP2 may process various signals received from a memory controller to provide the processed signals to TSV macros TM. In one or more example embodiments, the first and/or second signal processing block(s) SP1 and/or SP2 may perform a TSV repair function and/or a TSV macro TM repair function. As described above, the TSV repair logic of FIG. 1 may be implemented with the first and/or second signal processing block(s) SP1 and/or SP2. For example, the first and/or second signal processing block(s) SP1 and/or SP2 may preprocess a column/row address CA/RA to provide the preprocessed column/row address CA/RA to the TSV macro TM, based on a phase of a signal transmitted by a TSV macro.

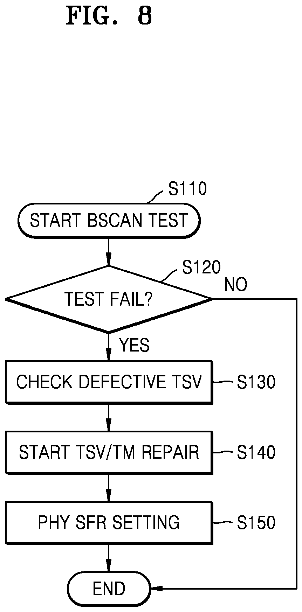

FIG. 8 is a flowchart illustrating a TSV repair operation method according to one or more example embodiments.

Referring to FIG. 8, the TSV repair operation method according to one or more example embodiments may correspond to a method which detects a defective TSV from among a plurality of TSVs of a logic die and a core die and bypasses a signal corresponding to the detected defective TSV. The TSV repair operation method may include operations performed in the logic die 100 of FIG. 1. In operation S110, a boundary scan (BSCAN) test may start. The BSCAN test may be a test for detecting a defective TSV of a logic die 100 and a memory die 200. In operation S120, whether a test fails may be determined. The logic die 100 may detect a defect of a TSV and/or a TSV macro, based on a result of the BSCAN test. When the test fails, operation S130 may be performed, and when the test succeeds, the operation method may end. In operation S130, the logic die 100 may check a defective TSV.

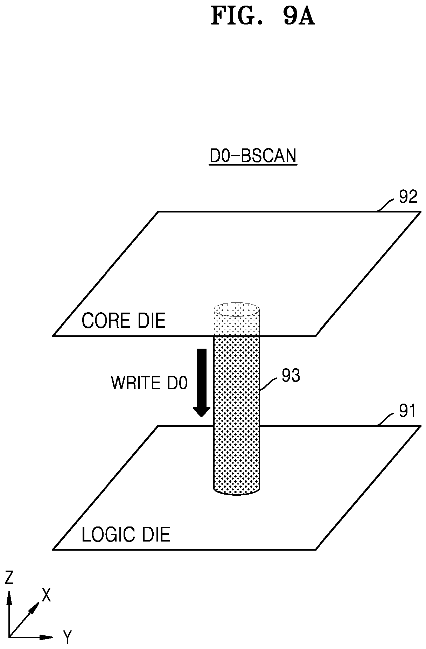

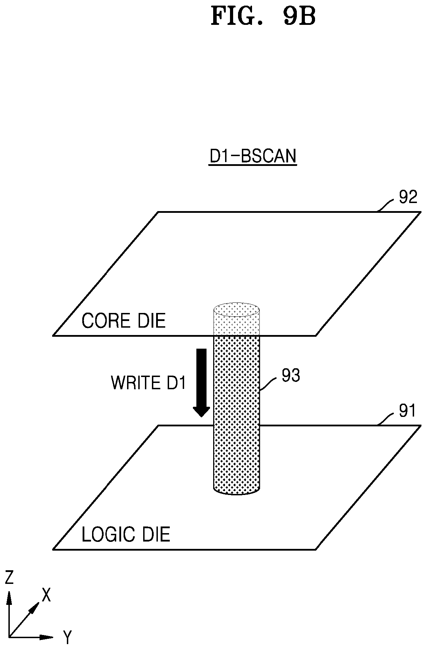

FIGS. 9A and 9B are diagrams illustrating a BSCAN test operation according to one or more example embodiments.

Referring to FIGS. 8 to 9B, a BSCAN test may include a first test DO-BSCAN and a second test D1-BSCAN. The first test DO-BSCAN may include, for example, an operation of transmitting write data D0 of a logic low level from a core die 92 to a logic die 91, namely, a write operation of data '0'. At this time, when the data '0' is read (e.g. received) in the logic die 91, a TSV 93 may be determined to be a normal TSV, and when data '1' is read (e.g. received) in the logic die 91, the TSV 93 may be determined to be a defective TSV. The second test D1-BSCAN may include, for example, an operation of transmitting write data D1 of a logic high level from the core die 92 to the logic die 91, namely, a write operation of data '1'. At this time, when the data '1' is read (e.g. received) in the logic die 91, the TSV 93 may be determined to be a normal TSV, and when data '0' is read (e.g. received) in the logic die 91, the TSV 93 may be determined to be a defective TSV.

Referring again to FIG. 8, in operation S140, the logic die 100 may start a TSV repair operation and a TSV macro repair operation, so as to bypass a transmission path of a signal corresponding to a defective TSV. In detail, the logic die 100 may change the transmission path of the signal to an adjacent TSV or a redundancy TSV instead of the defective TSV, and may change the transmission path of the signal to an adjacent TSV macro or a redundancy TSV macro instead of a defective TSV macro connected to the defective TSV. In operation S150, the logic die 100 may set an SFR of a physical region, so as to generate a control signal including TSV repair information. The TSV repair logic 121 of the logic die 100 may perform a TSV repair operation and a TSV macro repair operation, based on the SFR.

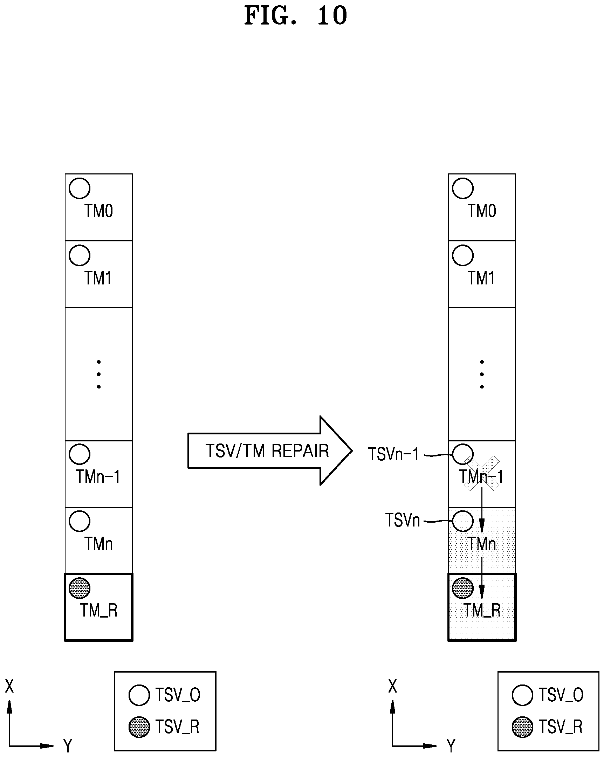

FIG. 10 is a diagram schematically illustrating a TSV repair operation according to one or more example embodiments.

Referring to FIG. 10, a plurality of TSV macros TM0 to TMn (where n may be a natural number) and a redundancy TSV macro TM_R may configure one lane or one set. A TSV repair logic (for example, 121 of FIG. 1) may perform a TSV repair operation for each lane or set, and a TSV repair unit may correspond to a lane or a set. The plurality of TSV macros TM0 to TMn may be respectively connected to a plurality of operation TSVs TSV_0, and the redundancy TSV macro TM_R may be connected to a redundancy TSV TSV_R. For example, the plurality of TSV macros TM0 to TMn and the redundancy TSV macro TM_R may be arranged in one row in a first direction X, but the disclosure is not limited thereto.

For example, when a defect occurs in one of the plurality of operation TSVs TSV_0 (e.g. TSVn-1), a TSV repair operation on a defective TSV TSVn-1 and a TSV macro repair operation on a TSV macro TMn-1 connected to the defective TSV TSVn-1 may be performed. A logic die may change a transmission path of a signal, corresponding to the defective TSV TSVn-1, to a TSV TSVn and a TSV macro TMn each adjacent to the defective TSV TSVn-1 and may change a transmission path of a signal, corresponding to the TSV TSVn, to the redundancy TSV TSV_R and the redundancy TSV macro TM_R. As described above, the TSV repair operation may include a shift operation to an adjacent TSV, and the TSV macro repair operation may perform a shift operation to an adjacent TSV macro.

However, the TSV repair operation according to one or more example embodiments is not limited to a shift operation to an adjacent TSV, and the TSV macro repair operation according to one or more example embodiments is not limited to a shift operation to an adjacent TSV macro. For example, the logic die may change the transmission path of the signal, corresponding to the defective TSV TSVn-1, to the redundancy TSV TSV_R and the redundancy TSV macro TM_R which are not adjacent to the defective TSV TSVn-1 and may not change the transmission path of the signal corresponding to the TSV TSVn. As described above, according to embodiments, a TSV repair operation and a TSV macro repair operation may be performed through SFR setting, and thus, the TSV repair operation may include a shift operation to a TSV which is not adjacent to the defective TSV, and the TSV macro repair operation may perform a shift operation to a TSV macro which is not adjacent to the defective TSV macro.

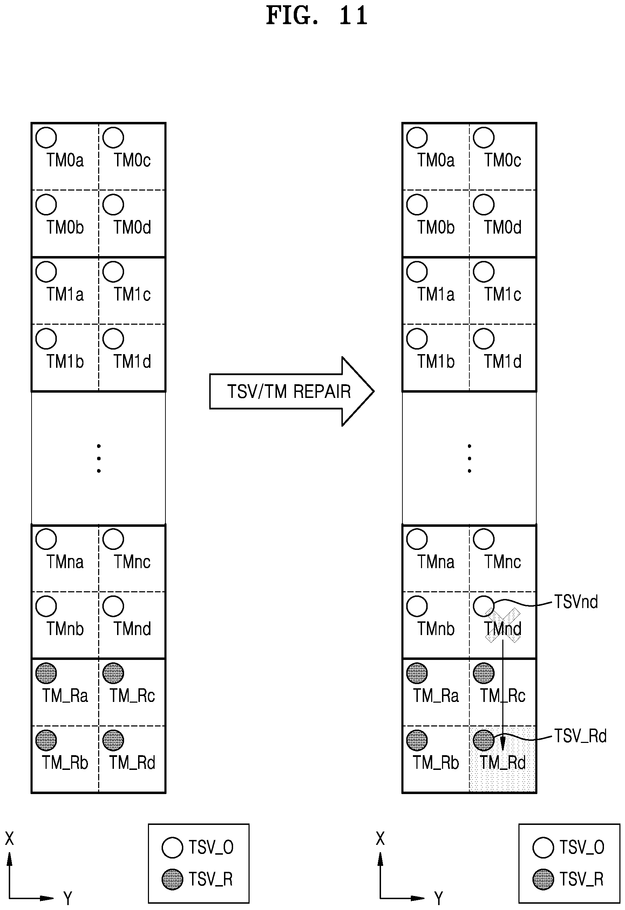

FIG. 11 is a diagram schematically illustrating a TSV repair operation according to one or more example embodiments.

Referring to FIG. 11, TSV macros TM0a, TM1a, ... TMna and a redundancy TSV macro TM_Ra may configure (e.g. may be included in, or may form) a first lane; TSV macros TM0b, TM1b, ... TMnb and a redundancy TSV macro TM_Rb may configure (e.g. may be included in, or may form) a second lane; TSV macros TM0c, TM1c, ... TMnc and a redundancy TSV macro TM_Rc may configure (e.g. may be included in, or may form) a third lane; and TSV macros TM0d, TM1d, ... TMnd and a redundancy TSV macro TM_Rd may configure (e.g. may be included, or may form) a fourth lane. For example, TSV macros TM0a to TMna and the redundancy TSV macro TM_Ra may correspond to a first channel, TSV macros TM0b to TMnb and the redundancy TSV macro TM_Rb may correspond to a second channel, TSV macros TM0c to TMnc and the redundancy TSV macro TM_Rc may correspond to a third channel, and TSV macros TM0d to TMnd and the redundancy TSV macro TM_Rd may correspond to a fourth channel.

In one or more example embodiments, a TSV repair logic may be implemented for each channel. For example, a first TSV repair logic corresponding to the first lane may perform, at a time, a repair operation on the TSV macros TM0a to TMna and a repair operation on TSVs respectively connected to the TSV macros TM0a to TMna, through remapping of signals corresponding to the first lane. For example, a second TSV repair logic corresponding to the second lane may perform, at a time, a repair operation on the TSV macros TM0b to TMnb and a repair operation on TSVs respectively connected to the TSV macros TM0b to TMnb, through remapping of signals corresponding to the second lane. For example, a third TSV repair logic corresponding to the third lane may perform, at a time, a repair operation on the TSV macros TM0c to TMnc and a repair operation on TSVs respectively connected to the TSV macros TM0c to TMnc, through remapping of signals corresponding to the third lane. For example, a fourth TSV repair logic corresponding to the fourth lane may perform, at a time, a repair operation on the TSV macros TM0d to TMnd and a repair operation on TSVs respectively connected to the TSV macros TM0d to TMnd, through remapping of signals corresponding to the fourth lane.

For example, when a defect occurs in a TSV TSVnd corresponding to the fourth channel among a plurality of operation TSVs TSV_0, a repair operation may be performed on the defective TSV TSVnd and the TSV macro TMnd connected to the defective TSV TSVnd. The logic die may change a transmission path of a signal, corresponding to the defective TSV TSVnd, to the redundancy TSV TSV_Rd and the redundancy TSV macro TM_Rd, based on remapping of signals corresponding to the fourth lane. As described above, the TSV repair operation may include a shift operation on TSVs corresponding to the same channel, and the TSV macro repair operation may perform a shift operation on TSV macros corresponding to the same channel. In other words, as illustrated in FIG. 11, in a case where a plurality of TSV macros respectively included in a plurality of lanes are provided as one set, a TSV repair operation may not be limited to a shift operation to an adjacent TSV, and a TSV macro repair operation may not be limited to a shift operation to an adjacent TSV macro.

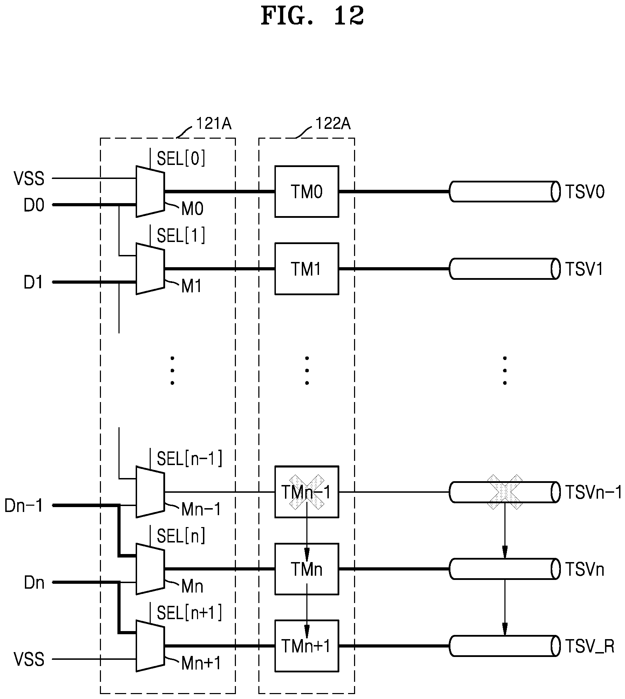

FIG. 12 is a diagram illustrating a TSV repair logic 121A and TSV macros 122A according to one or more example embodiments.

Referring to FIG. 12, the TSV repair logic 121A may include a plurality of selectors M0 to Mn+1, and the TSV macros 122A may include a plurality of TSV macros TM0 to TMn+1. The plurality of selectors M0 to Mn+1 may respectively correspond to the plurality of TSV macros TM0 to TMn+1, and the plurality of TSV macros TM0 to TMn+1 may respectively correspond to a plurality of TSVs TSV0 to TSVn and TSV_R. In this case, the plurality of TSV macros TM0 to TMn+1 may configure (e.g. may be included in, or may form) one lane, and the TSV repair logic 121A may perform a TSV macro repair operation on the plurality of TSV macros TM0 to TMn+1 included in one lane and a TSV repair operation on the plurality of TSVs TSV0 to TSVn and TSV_R.

The TSV repair logic 121A may perform a repair operation on the plurality of TSV macros TM0 to TMn+1 and the plurality of TSVs TSV0 to TSVn and TSV_R in response to a control signal SEL[n+1:0]. For example, the control signal SEL[n+1:0] may be generated through SFR setting based on an APB interface. For example, each of the plurality of selectors M0 to Mn+1 may include a multiplexer. The selector M0 may output a first input (for example, VSS) or first data D0 in response to a control signal SEL[0], and the selector M1 may output the first data D0 or second data D1 in response to a control signal SEL[1]. The selector Mn may output n-1^{th} data Dn-1 or n^{th} data Dn in response to a control signal SEL[n], and the selector Mn+1 may output the n^{th} data Dn or a second input (for example, VSS) in response to a control signal SEL[n+1]. That is, each selector may output one of two input signals dependent on a corresponding control signal. For each of the selectors other than a first selector (M0) and the selector corresponding to the redundancy TSV_R (Mn+1), the two inputs may comprise a first input for receiving data initially allocated to the corresponding TSV, and a second input for receiving data initially allocated to an adjacent (e.g. preceding) TSV.

For example, when a TSV TSVn-1 is a defective TSV, the TSV repair logic 121A may perform remapping on the n-1^{th} and n^{th} data Dn-1 and Dn in response to the control signal SEL[n+1:0], and thus, may change transmission paths of the n-1^{th} and n^{th} data Dn-1 and Dn. In detail, the selector Mn may output the n-1^{th} data Dn-1 in response to the control signal SEL[n], and the n-1^{th} data Dn-1 may be transmitted to a core die through the TSV macro TMn and the TSV TSVn. Also, the selector Mn+1 may output the n^{th} data Dn in response to the control signal SEL[n+1], and the n^{th} data Dn may be transmitted to the core die through the TSV macro TMn+1 and the redundancy TSV TSV_R.

More generally, when a TSV TSVn-i (where i is an integer greater than or equal to 1 and less than or equal to n) is a defective TSV, the TSV repair logic 121A may perform remapping on the n-i^{th} to n^{th} data Dn-i to Dn in response to the control signal SEL[n+1:0], and thus, may change transmission paths of the n-i^{th} to n^{th} data Dn-i to Dn. Each selector from the selector Mn-i+1 adjacent to (e.g. succeeding) the defective selector Mn-i to the last selector Mn+1 may be controlled to output data that was previously allocated to the corresponding adjacent (e.g. preceding) selector. For instance, the selector Mn-i+1 may output the n-i^{th} data Dn-i in response to the control signal SEL[n-i+1], the selector Mn-i+2 may output the n-i+1^{th} data Dn-i+1 in response to the control signal SEL[n-i+2], ..., and the selector Mn+1 may output the n^{th} data Dn in response to the control signal SEL[n+1]. Accordingly, the data for each TSV from the defective TSV to the last operational TSV may be shifted to an adjacent TSV.

FIG. 13 illustrates a plurality of lanes according to one or more example embodiments.

Referring to FIG. 13 in conjunction with FIG. 1, the plurality of lanes may include a first lane 131 and a second lane 132 adjacent to each other in a second direction Y. For example, the TSV repair logic 121 of the logic die 100 may include a first TSV repair logic corresponding to the first lane 131 and a second TSV repair logic corresponding to the second lane 132. The first TSV repair logic may perform a TSV repair operation and/or a TSV macro repair operation on the first lane 131, and the second TSV repair logic may perform a TSV repair operation and/or a TSV macro repair operation on the second lane 132.

In one or more example embodiments, a number of TSV macros included in each of the first and second lanes 131 and 132 may be equal to each other. The first lane 131 may include TSV macros TM0 to TM8 and a redundancy TSV macro TM_R0, which are arranged in one row in a first direction X. The TSV macros TM0 to TM8 may be respectively connected to data TSVs TSV_D through which data is transmitted, and the redundancy TSV macro TM_R0 may be connected to a redundancy TSV TSV_R0. The second lane 132 may include TSV macros TM10 to TM18 and a redundancy TSV macro TM_R1, which are arranged in one row in the first direction X. The TSV macros TM10 to TM18 may be respectively connected to the data TSVs TSV_D through which data is transmitted, and the redundancy TSV macro TM_R1 may be connected to a redundancy TSV TSV_R1.

For example, when a TSV connected to the TSV macro TM6 is a defective TSV or the TSV macro TM6 is defective, the logic die 100 may perform remapping on signals respectively corresponding to the TSV macros TM6 to TM8, and thus, may sequentially shift transmission paths of signals respectively corresponding to the TSV macros TM6 to TM8. For example, the logic die 100 may change a transmission path of a signal, corresponding to the TSV macro TM6, to the TSV macro TM7 and a TSV connected to the TSV macro TM7, change a transmission path of a signal, corresponding to the TSV macro TM7, to the TSV macro TM8 and a TSV connected to the TSV macro TM8, and change a transmission path of a signal, corresponding to the TSV macro TM8, to the redundancy TSV macro TM_R0 and the redundancy TSV TSV_R.

FIG. 14 illustrates a plurality of lanes according to one or more example embodiments.

Referring to FIG. 14 in conjunction with FIG. 1, the plurality of lanes may include third to fifth lanes 141 to 143 adjacent to one another in a second direction Y. For example, the TSV repair logic 121 of the logic die 100 may include a third TSV repair logic corresponding to the third lane 141, a fourth TSV repair logic corresponding to the fourth lane 142, and a fifth TSV repair logic corresponding to the fifth lane 143. The third TSV repair logic may perform a TSV repair operation and/or a TSV macro repair operation on the third lane 141, the fourth TSV repair logic may perform a TSV repair operation and/or a TSV macro repair operation on the fourth lane 142, and the fifth TSV repair logic may perform a TSV repair operation and/or a TSV macro repair operation on the fifth lane 143.

In one or more example embodiments, a number of TSV macros included in each of the third to fifth lanes 141 to 143 may be the same or differ. For example, the third lane 141 may include TSV macros TM20 to TM28 and a redundancy TSV macro TM_R2, which are arranged in one row in a first direction X. The TSV macros TM20 to TM28 may be respectively connected to column address TSVs TSV_CA through which a column address CA is transmitted, and the redundancy TSV macro TM_R2 may be connected to a redundancy TSV TSV_R. The fourth lane 142 may include TSV macros TM30 to TM38 and a redundancy TSV macro TM_R3, which are arranged in one row in the first direction X. The TSV macros TM30 to TM38 may be respectively connected to row address TSVs TSV_RA through which a row address RA is transmitted, and the redundancy TSV macro TM_R3 may be connected to the redundancy TSV TSV_R. The fifth lane 143 may include TSV macros TM40 and TM41 and a redundancy TSV macro TM_R4, which are arranged in one row in the first direction X. The TSV macros TM40 to TM41 may be respectively connected to clock TSVs TSV_CK through which a clock signal is transmitted, and the redundancy TSV macro TM_R4 may be connected to a redundancy TSV TSV_R.

For example, when a TSV connected to the TSV macro TM41 is a defective TSV or the TSV macro TM41 is defective, the logic die 100 may perform remapping on a signal corresponding to the TSV macro TM41, and thus, may shift a transmission path of the signal corresponding to the TSV macro TM41. For example, the logic die 100 may change the transmission path of the signal, corresponding to the TSV macro TM41, to the redundancy TSV macro TM_R4 and the redundancy TSV TSV_R.

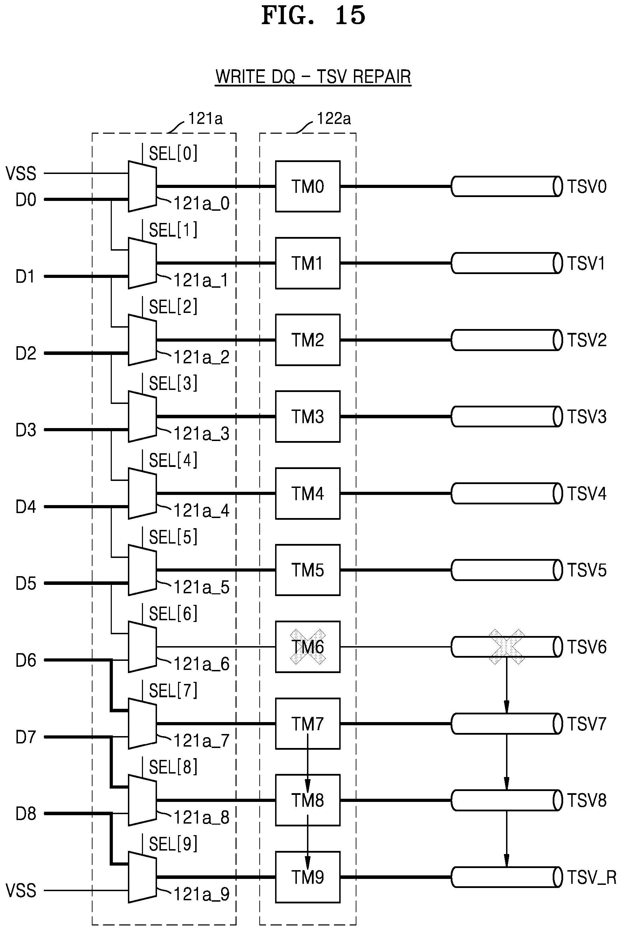

FIG. 15 is a diagram schematically illustrating a TSV repair operation when transmitting write data, according to one or more example embodiments.

Referring to FIG. 15 in conjunction with FIG. 1, a first TSV repair logic 121a may include a plurality of selectors 121a_0 to 121a_9 and may perform a repair operation on a plurality of TSV macros TM0 to TM8 and a redundancy TSV macro TM9 configuring a first lane 122a that is used as a write path. The plurality of TSV macros TM0 to TM8 may be respectively connected to a plurality of data TSVs or a plurality of TSVs TSV0 to TSV8, and the redundancy TSV macro TM9 may be connected to a redundancy TSV TSV_R. In a data write operation, the logic die 100 may transmit pieces of data D0 to D8 to the memory die 200 through the plurality of TSVs TSV0 to TSV8 and the redundancy TSV TSV_R.

For example, when a defect occurs in the TSV TSV6 and/or a defect occurs in the TSV macro TM6, a control signal SEL[9:0] may be generated such that transmission paths of the data D6 to D8 respectively corresponding to the TSVs TSV6 to TSV8 are shifted. For example, the control signal SEL[9:0] may correspond to an example of the control signal SEL_A of FIG. 4 and may be generated through SFR setting. According to one or more example embodiments, the control signal SEL[9:0] may be referred to as a remapping signal, a repair signal, or a selection signal. In detail, in response to the control signal SEL[9:0], the first TSV repair logic 121a may generate remapped data from the data D0 to D8 received thereby and may provide the remapped data to each of corresponding TSV macros, and thus, may perform a TSV macro repair operation and a TSV repair operation at a time.

The selectors 121a_0 to 121a_5 may respectively output the data D0 to D5 in response to a control signal SEL[5:0]. Therefore, the data D0 to D5 may be respectively transmitted to TSVs through the TSV macros TM0 to TM5. That is, the data previously corresponding to TSVs and/or TSV macros preceding the defective TSV TSV6 and/or defective TSV macro TM6 may not be remapped (e.g. may keep the previous mapping). The selector 121a_7 may output the data D6 in response to a control signal SEL[7], and the data D6 may be transmitted to the TSV TSV7 through the TSV macro TM7. The selector 121a_8 may output the data D7 in response to a control signal SEL[8], and the data D7 may be transmitted to the TSV TSV8 through the TSV macro TM8. The selector 121a_9 may output the data D8 in response to a control signal SEL[9], and the data D8 may be transmitted to the TSV TSV_R through the TSV macro TM9. That is, the data previously corresponding to the defective TSV TSV6 and/or defective TSV macro TM6 and TSVs defective TSV TSV6 and/or defective TSV macro TM6 may be remapped (e.g. may be shifted to an adjacent TSV macro). In this case, information about the defective TSV TSV6 and/or the defective TSV macro TM6 may be shared by the logic die 100 and the memory die 200, and the TSV TSV6 and the TSV macro TM6 may not be used in the transmission or reception of a signal.

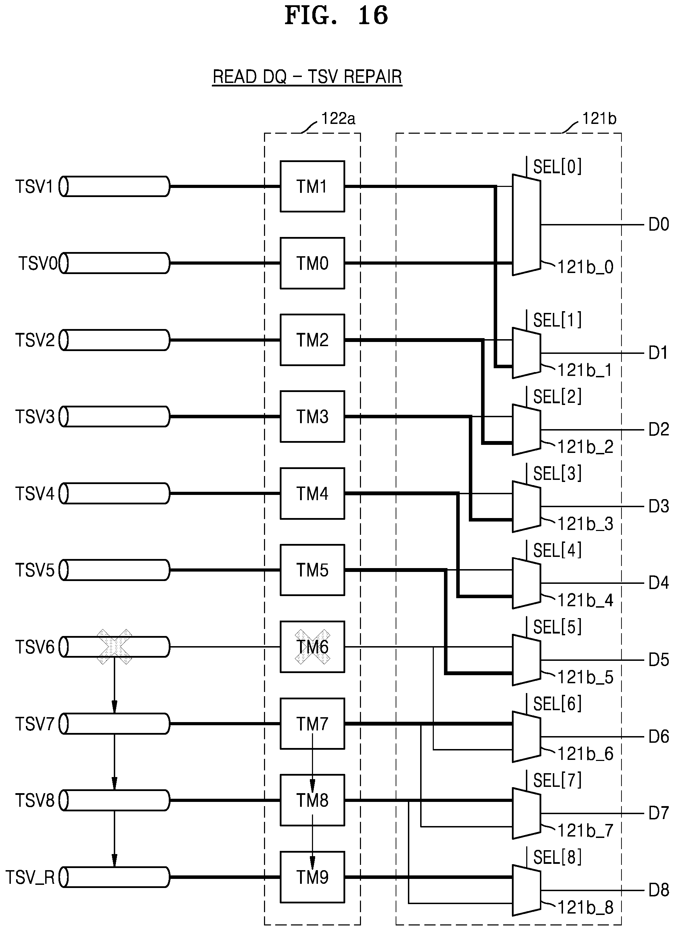

FIG. 16 is a diagram schematically illustrating a TSV repair operation when transmitting read data, according to one or more example embodiments.

Referring to FIG. 16 in conjunction with FIG. 1, a second TSV repair logic 121b may include a plurality of selectors 121b_0 to 121b_8 and may perform a repair operation on a plurality of TSV macros TM0 to TM8 and a redundancy TSV macro TM9 configuring a first lane 122a that is used as a read path. The plurality of TSV macros TM0 to TM8 may be respectively connected to a plurality of data TSVs or a plurality of TSVs TSV0 to TSV8, and the redundancy TSV macro TM9 may be connected to a redundancy TSV TSV_R. In a data read operation, the logic die 100 may receive pieces of data D0 to D8 from the memory die 200 through the plurality of TSVs TSV0 to TSV8 and the redundancy TSV TSV_R.

For example, when a defect occurs in the TSV TSV6 and/or a defect occurs in the TSV macro TM6, a control signal SEL[8:0] may be generated such that reception paths of the data D6 to D8 respectively corresponding to the TSVs TSV6 to TSV8 are shifted. For example, the control signal SEL[8:0] may correspond to an example of the control signal SEL_B of FIG. 4 and may be generated through SFR setting. According to one or more example embodiments, the control signal SEL[8:0] may be referred to as a remapping signal, a repair signal, or a selection signal. In detail, in response to the control signal SEL[8:0], the second TSV repair logic 121b may generate remapped data D0 to D8 from data received through the first lane 122a and may transmit the remapped data D0 to D8 to the memory controller 110.

The selectors 121b_0 to 121b_5 may respectively output the data D0 to D5 in response to a control signal SEL[5:0]. That is, the data previously corresponding to TSVs and/or TSV macros preceding the defective TSV TSV6 and/or defective TSV macro TM6 may not be remapped (e.g. may keep the previous mapping). The selector 121b_6 may output the data D6 (received over TSV7) in response to a control signal SEL[6], the selector 121b_7 may output the data D7 (received over TSV8) in response to a control signal SEL[7], and the selector 121b_8 may output the data D8 (received over TSV_R) in response to a control signal SEL[8]. For example, the output data D0 to D8 may be transmitted to the memory controller 110 as read data.

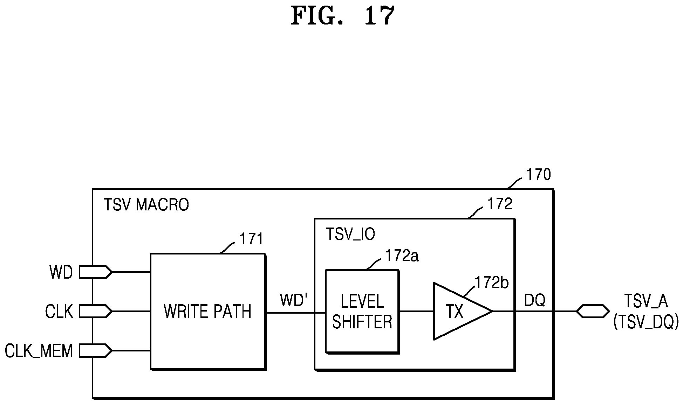

FIG. 17 is a block diagram schematically illustrating a TSV macro 170 according to one or more example embodiments.

Referring to FIG. 17 in conjunction with FIG. 1, the TSV macro 170 may be connected to a first TSV TSV_A, and the first TSV TSV_A may correspond to a data TSV TSV_DQ through which data DQ transmitted from the logic die 100 to the memory die 200 is transmitted. For example, the TSV macro 170 may correspond to an implementation example of one of the TSV macros TM of FIGS. 6A to 7C, the TSV macros TM0 to TM_R of FIG. 10, the TSV macros TM0 to TMn+1 of FIG. 12, the TSV macros TM0 to TM_R1 of FIG. 13, the TSV macros TM20 to TM_R4 of FIG. 14, and the TSV macros TM0 to TM9 of FIGS. 15 and 16.

The TSV macro 170 may include a write path 171 and an I/O circuit 172. The write path 171 may generate (e.g. synchronize) write data WD, received from the memory controller 110, with a memory clock CLK_MEM and may thus generate synchronized write data WD'. In detail, the write path 171 may perform a synchronization operation on the write data WD, based on a controller clock CLK and the memory clock CLK_MEM. In this case, the controller clock CLK may be a clock signal based on a first clock domain of the logic die 100, and the memory clock CLK_MEM may be a clock signal based on a second clock domain of the memory die 200.

The I/O circuit 172 may include a level shifter 172a and a transmitter 172b. The level shifter 172a may shift a voltage level of the synchronized write data WD' from a first voltage level based on a first voltage domain of the memory controller 110 to a second voltage level based on a second voltage domain of the memory die 200. However, the disclosure is not limited thereto, and the I/O circuit 172 may not include the level shifter 172a.

According to one or more example embodiments, the level shifter 172a may be referred to as a logic level shifter or a voltage level translation and may be defined as a circuit which is used to translate a signal from one logic level or voltage domain into another logic level or voltage domain. Because the level shifter 172a is used, compatibility between integrated circuits having different voltage requirements may be allowed. The transmitter 172b may output write data, where a voltage level is shifted, to the first TSV TSV_A.

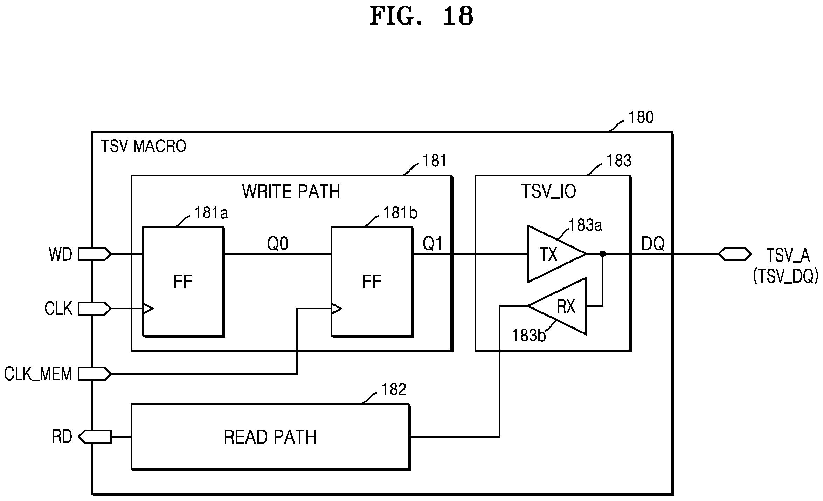

FIG. 18 is a block diagram illustrating a TSV macro 180 according to one or more example embodiments.

Referring to FIG. 18 in conjunction with FIG. 1, the TSV macro 180 may be connected to a first TSV TSV_A, and the first TSV TSV_A may correspond to a data TSV TSV_DQ through which data DQ is transmitted. For example, the TSV macro 180 may correspond to an implementation example of the TSV macro 170 of FIG. 17. The TSV macro 180 may include a write path 181, a read path 182, and an I/O circuit 183. When the TSV macro 180 is used as a write path, write data WD may be output to the memory die 200 through the write path 181, the I/O circuit 183, and the first TSV TSV_A. When the TSV macro 180 is used as a read path, the data DQ received through the first TSV TSV_A may be transmitted as read data RD to the memory controller 110 through the I/O circuit 183 and the read path 182.

The write path 181 may include flip-flops 181a and 181b. For example, the write path 181 may correspond to an implementation example of the write path 171 of FIG. 17. For example, the flip-flops 181a and 181b may be D flip-flops. The flip-flop 181a may receive the write data WD from the memory controller 110, receive a controller clock CLK through a clock terminal, and output a first signal Q0. The flip-flop 181b may receive the first signal Q0 from the flip-flop 181a, receive a memory clock CLK_MEM through a clock terminal, and output a second signal Q1. At this time, the flip-flop 181b may synchronize the first signal Q0 with the memory clock CLK_MEM to output the second signal Q1. A transmitter 183a included in the I/O circuit 183 may output data DQ corresponding to the second signal Q1 to the first TSV TSV_A, and the data DQ may be transmitted to the memory die 200 through the first TSV TSV_A. In one or more example embodiments, a delay control logic may be disposed between the write path 181 and the I/O circuit 183.

For example, the flip-flop 181a may latch the write data WD at a rising edge of the controller clock CLK to output the first signal Q0. The flip-flop 181b may latch the first signal Q0 at a rising edge of the memory clock CLK_MEM to output the second signal Q1. At this time, a phase difference between the controller clock CLK and the memory clock CLK_MEM may be variously changed according to embodiments. For example, the memory clock CLK_MEM may be a clock having the same phase as that of the controller clock CLK. For example, the memory clock CLK_MEM may have a 90-degree phase difference with the controller clock CLK. For example, the memory clock CLK_MEM may have a 180-degree phase difference with the controller clock CLK. For example, the memory clock CLK_MEM may have a 270-degree phase difference with the controller clock CLK.

A receiver 183b included in the I/O circuit 183 may output the data DQ, received from the memory die 200 through the first TSV TSV_A, to the read path 182. In one or more example embodiments, the read path 182 may de-serialize the data DQ and may synchronize de-serialized data with the controller clock CLK to output read data RD. For example, the read data RD output from the read path 182 may be transmitted to the memory controller 110.

According to one or more example embodiments, the write data WD may include the data DQ, a column address CA, a row address RA, an ECC signal, a severity signal SEV, the controller clock CLK, the memory clock CLK_MEM, a memory write clock WCK, a memory read clock BRCK, a read clock CRCK, and a stack identification SID. According to one or more example embodiments, the read data RD may include the data DQ. As described above, a data DQ-related signal may be used in a write repair operation and a read repair operation, and some signals such as the column address CA and the row address RA may be used only in the write repair operation.

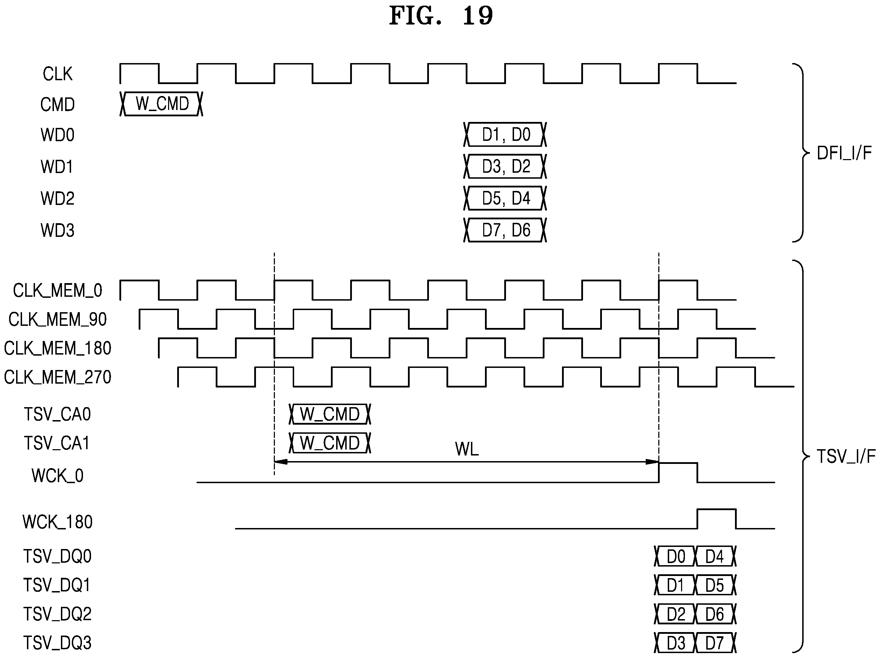

FIG. 19 is a timing diagram illustrating a data transmission operation based on the TSV macro 180 of FIG. 18, according to one or more example embodiments.

Referring to FIG. 19 in conjunction with FIGS. 1 and 18, the memory controller 110 of the logic die 100 may generate a write command W_CMD and pieces of write data WD0 to WD3 and may operate based on a controller clock CLK. For example, the memory controller 110 may transmit the write command W_CMD and the write data WD0 to WD3 to the interface circuit 120 through a DFI interface DFI_I/F. For example, the write data WD0 may include pieces of parallel data D1 and D0, the write data WD1 may include pieces of parallel data D3 and D2, the write data WD2 may include pieces of parallel data D5 and D4, and the write data WD3 may include pieces of parallel data D7 and D6. The controller clock CLK may be a signal which toggles based on a clock domain of the logic die 100 (e.g. based on a clock frequency of the logic die 100).

The interface circuit 120 may transmit the data DQ to the memory die 200 through the DFI interface DFI_I/F. Memory clocks CLK_MEM_0, CLK_MEM_90, CLK_MEM _180, and CLK_MEM_270 may be generated to have a 90-degree phase difference therebetween. For example, the write command W_CMD may be transmitted through column address TSVs TSV_CA0 and TSV_CA1. After write latency WL, the data DQ may be transmitted through data TSVs TSV_DQ0 to TSV_DQ3. For example, the data D0 to D3 may be synchronized with a write clock WCK_0 and may be respectively transmitted through the data TSVs TSV_DQ0 to TSV_DQ3, and the data D4 to D7 may be synchronized with a write clock WCK_180 and may be respectively transmitted through the data TSVs TSV_DQ0 to TSV_DQ3. The memory clocks CLK_MEM_0, CLK_MEM_90, CLK_MEM_180, and CLK_MEM_270 may each be a signals which toggles based on a clock domain of the memory die 200 (e.g. at a clock frequency of the memory die 200), and the write clocks WCK_0 and WCK_180 may each be a signal which toggles in only a write operation period. The write clocks WCK_0 and WCK_180 may toggle during the write operation period based on a clock domain of the memory die 200 (e.g. at a clock frequency of the memory die 200).

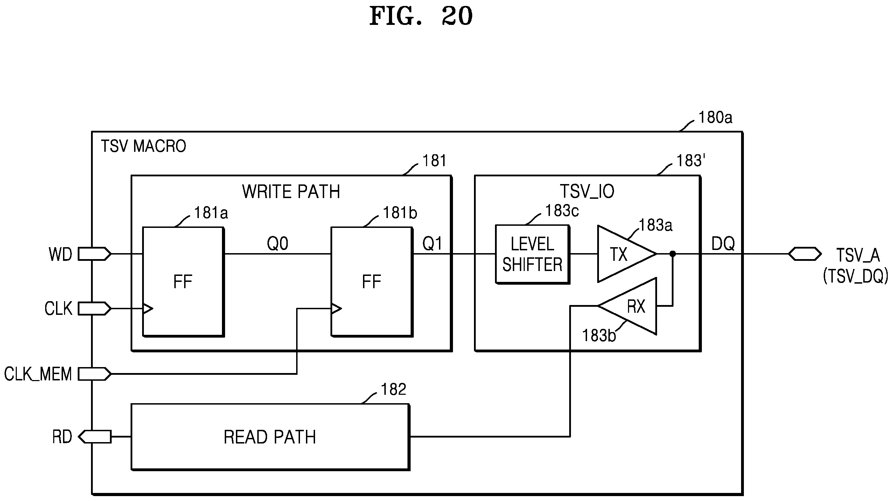

FIG. 20 is a block diagram illustrating a TSV macro 180a according to one or more example embodiments.

Referring to FIG. 20, the TSV macro 180a may correspond to a modified example of the TSV macro 180 of FIG. 18, and the descriptions described above with reference to FIGS. 18 and 19 may be applied to the embodiment of FIG. 20. The TSV macro 180a may include an I/O circuit 183', and comparing with the I/O circuit 183 of FIG. 18, the I/O circuit 183' may further include a level shifter 183c. The level shifter 183c may shift a voltage level of a second signal Q1 to a voltage level based on a voltage domain of a memory die (for example, 200 of FIG. 1).

FIG. 21 is a block diagram illustrating a TSV macro 210 according to one or more example embodiments.

Referring to FIG. 21, the TSV macro 210 may be connected to a second TSV TSV_B, and the second TSV TSV_B may correspond to a signal TSV through which a signal transmitted and received between the logic die 100 and the memory die 200 is transmitted. For example, the second TSV TSV_B may correspond to a TSV TSV_CA through which a column address CA is transmitted, a TSV TSV_RA through which a row address RA is transmitted, or a TSV TSV_CK through which a clock signal CK is transmitted. For example, the clock signal CK may include a memory clock CLK_MEM, a write clock WCK, and a read clock CRCK. The memory clock CLK_MEM may always toggle, the write clock WCK may toggle in only a write operation period, and the read clock CRCK may toggle in only a read operation period.

The TSV macro 210 may include a write path 211, a read path 212, an I/O circuit 213, and a phase shift logic 214. The I/O circuit 213 may include a transmitter 213a and a receiver 213b, the transmitter 213a may output a signal, received through the write path 211, to the second TSV TSV_B, and the receiver 213b may output a signal, received through the second TSV TSV_B, to the read path 212. For example, the TSV macro 210 may correspond to an implementation example of one of the TSV macros TM of FIGS. 6A to 7C, the TSV macros TM0 to TM_R of FIG. 10, the TSV macros TM0 to TMn+1 of FIG. 12, the TSV macros TM0 to TM_R1 of FIG. 13, the TSV macros TM20 to TM_R4 of FIG. 14, and the TSV macros TM0 to TM9 of FIG. 15.

The write path 211 may include flip-flops 211a and 211b. For example, the flip-flops 211a and 211b may be D flip-flops. The flip-flop 211a may receive write data WD, receive a controller clock CLK through a clock terminal, and output a first signal Q0. For example, the write data WD may include a column address CA, a row address RA, and/or a clock signal CK. The flip-flop 211b may receive the first signal Q0 from the flip-flop 211a, receive a memory clock CLK_MEM through a clock terminal, and output a second signal Q1. The flip-flop 211b may synchronize the first signal Q0 with the memory clock CLK_MEM to output the second signal Q1.

At this time, a synchronization clock phase (e.g., a phase of the memory clock CLK_MEM) may differ based on the write data WD. Therefore, when the write data WD input to the TSV macro 210 is changed by a TSV repair operation or a TSV macro repair operation, the phase shift logic 214 for shifting a phase of the memory clock CLK_MEM input to the second flip-flip 211b may be needed. For example, when the TSV macro 210 is a redundancy TSV macro or a repair TSV macro to which remapped write data WD is input, the phase shift logic 214 may shift a phase of the memory clock CLK_MEM.

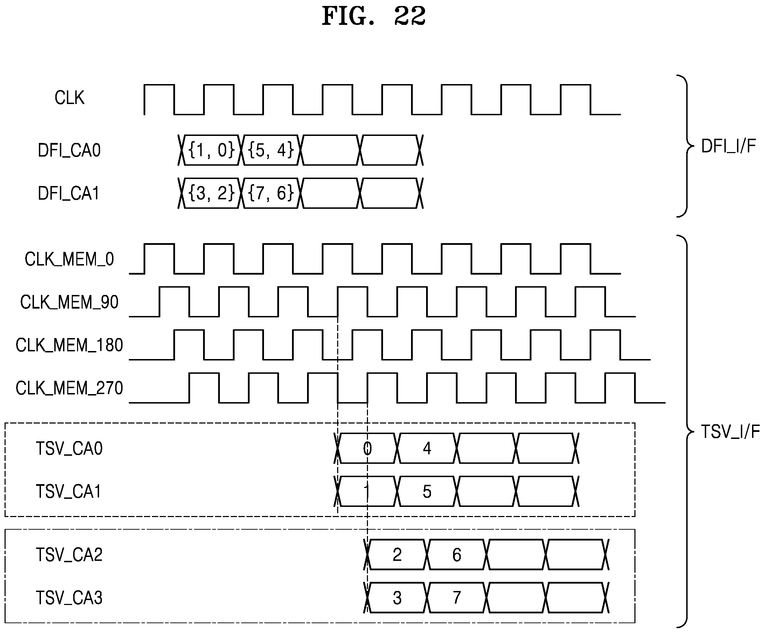

In one or more example embodiments, the phase shift logic 214 may include a selector 214a and inverters 214b to 214d. The inverters 214b and 214c may configure (e.g. form) a buffer and may buffer the memory clock CLK_MEM to be output to a first input terminal of the selector 214a. The inverter 214d may invert an output of the inverter 214c to be output to a second input terminal of the selector 214a. Therefore, memory clocks input to the first and second input terminals of the selector 214a may have a 180-degree phase difference. For example, a memory clock (for example, CLK_MEM_90 of FIG. 22) may be input to the first input terminal of the selector 214a, and a memory clock (for example, CLK_MEM_270 of FIG. 22) may be input to the second input terminal of the selector 214a.

The phase shift logic 214 may shift a phase of the memory clock CLK_MEM in response to a control signal SEL. For example, the control signal SEL may correspond to an example of the control signal SEL_C of FIG. 4 and may be generated through SFR setting. According to one or more example embodiments, the control signal SEL may be referred to as a phase shift signal, a selection signal, or a repair signal. In detail, the phase shift logic 214 may output the memory clock CLK_MEM having a shifted phase, based on the control signal SEL, and thus, the flip-flop 211b may synchronize a first signal Q0 with the memory clock CLK_MEM having the shifted phase.

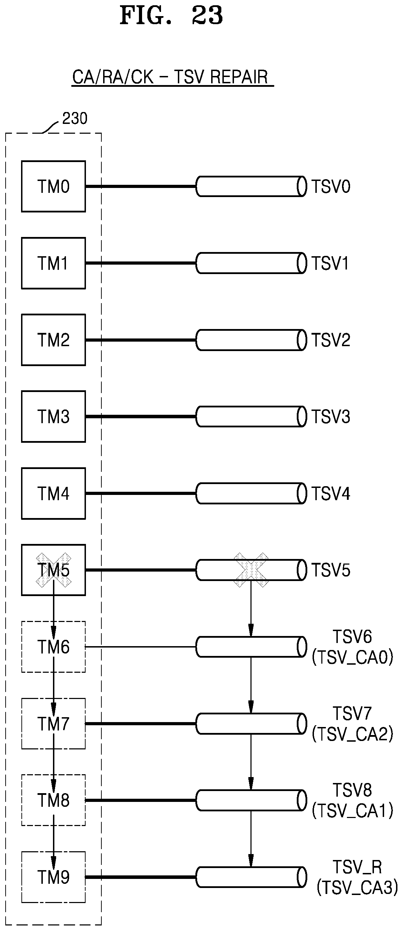

FIG. 22 is a timing diagram illustrating a signal transmission operation based on the TSV macro 210 of FIG. 21, according to one or more example embodiments. FIG. 23 is a diagram schematically illustrating a TSV repair operation when transmitting a signal, according to one or more example embodiments.

Referring to FIGS. 1 and 21 to 23, the memory controller 110 of the logic die 100 may transmit column addresses to the interface circuit 120 through a DFI interface DFI_I/F. For example, the memory controller 110 may transmit column addresses DFI_CA0 and DFI_CA1 based on the DFI interface DFI_I/F to the interface circuit 120. The controller clock CLK may be a signal which toggles based on a clock domain of the logic die 100.

The interface circuit 120 may transmit a column address to the memory die 200 through a TSV interface TSV_I/F. Memory clocks CLK_MEM_0, CLK_MEM_90, CLK_MEM _180, and CLK_MEM_270 may be generated to have a 90-degree phase difference therebetween. For example, the column addresses DFI_CA0 may be synchronized with the memory clock CLK_MEM_90 and may be transmitted to TSVs TSV_CA0 and TSV_CA1, and the column addresses DFI_CA1 may be synchronized with the memory clock CLK_MEM_270 and may be transmitted to TSVs TSV_CA2 and TSV_CA3.

For example, TSVs TSV5 to TSV8 may respectively correspond to column addresses. In detail, a column address CA0 may be allocated to the TSV TSV5, a column address CA2 may be allocated to the TSV TSV6, a column address CA1 may be allocated to the TSV TSV7, and a column address CA3 may be allocated to the TSV TSV8. For example, when a defect occurs in the TSV TSV5 of the TSVs TSV5 to TSV8 and/or a defect occurs in a TSV macro connected to the TSV TSV5, the logic die 100 may perform remapping on the column addresses CA0 to CA3, and thus, transmission paths of the column addresses CA0 to CA3 may be changed.

For example, the column address CA0 may be transmitted through the TSV TSV6 and a TSV macro TM6, the column address CA2 may be transmitted through the TSV TSV7 and a TSV macro TM7, the column address CA1 may be transmitted through the TSV TSV8 and a TSV macro TM8, and the column address CA3 may be transmitted through a TSV TSV_R and a TSV macro TM9.

At this time, the column addresses CA0 and CA1 needs to be synchronized with the memory clock CLK_MEM_90, and thus, a control signal SEL applied to the TSV macros TM6 and TM8 may be generated to select a signal corresponding to a first input terminal of a selector 214a. Therefore, the TSV macro TM6 may synchronize the column address CA0 with the memory clock CLK_MEM_90 in response to the control signal SEL, and the TSV macro TM8 may synchronize the column address CA1 with the memory clock CLK_MEM_90 in response to the control signal SEL.

Also, the column addresses CA2 and CA3 needs to be synchronized with the memory clock CLK_MEM_270, and thus, a control signal SEL applied to the TSV macros TM7 and TM9 may be generated to select a signal corresponding to a second input terminal of the selector 214a. Therefore, the TSV macro TM7 may synchronize the column address CA2 with the memory clock CLK_MEM_270 in response to the control signal SEL, and the TSV macro TM9 may synchronize the column address CA3 with the memory clock CLK_MEM_270 in response to the control signal SEL.

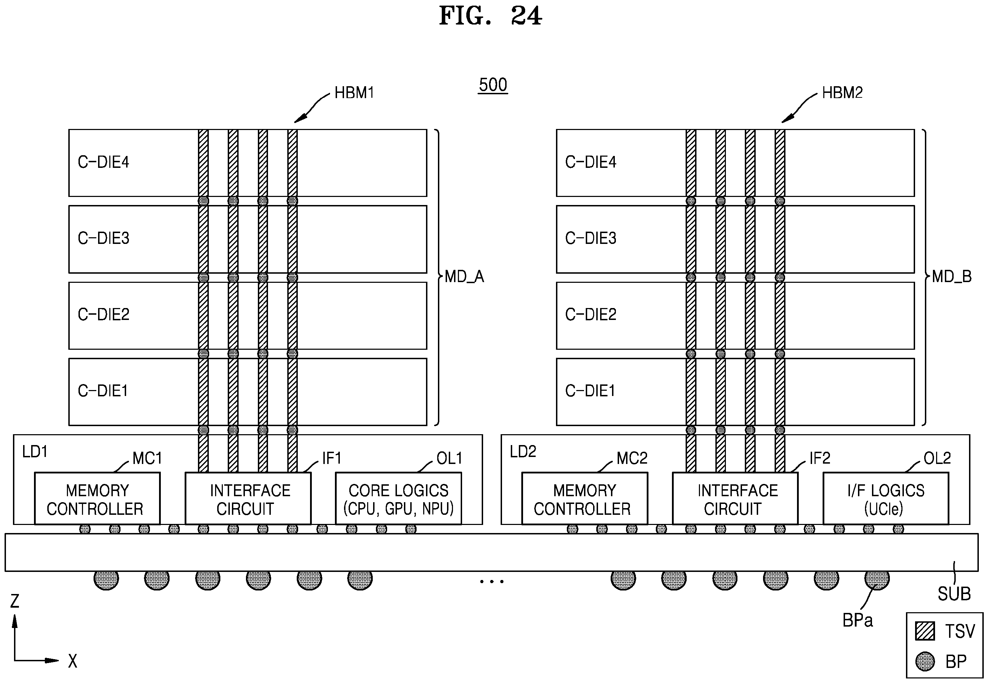

FIG. 24 is a diagram illustrating an HBM semiconductor device 500 according to one or more example embodiments.

Referring to FIG. 24, the HBM semiconductor device 500 may include first and second HBMs HBM1 and HBM2 disposed on a substrate SUB. For example, the first and second HBMs HBM1 and HBM2 may be disposed adjacent to each other in a first direction X on an upper surface of the substrate SUB and may be electrically connected to the substrate SUB through bumps BP. A plurality of connection terminals (for example, bumps BPa) may be disposed on a lower surface of the substrate SUB, and the substrate SUB may be electrically connected to an external device (for example, a printed circuit board (PCB)) through the bumps BPa.

The first HBM HBM1 may include a first logic die LD1 and a plurality of memory dies MD_A which are stacked in a vertical direction Z on the first logic die LD1. The second HBM HBM2 may include a second logic die LD2 and a plurality of memory dies MD_B which are stacked in the vertical direction Z on the second logic die LD2. For example, each of the plurality of memory dies MD_A and the plurality of memory dies MD_B may include first to fourth core dies C-DIE1 to C-DIE4. The first to fourth core dies C-DIE1 to C-DIE4 may include a plurality of channels including an independent interface, and thus, each of the first and second HBMs HBM1 and HBM2 may have an increased bandwidth.

The first and second HBMs HBM1 and HBM2 may each include a logic die according to the one or more embodiments described above with reference to FIGS. 1 to 23. In detail, a logic die LD1 of the first HBM HBM1 may include a memory controller MC1, an interface circuit IF1, and core logics OL1, and for example, the core logics OL1 may include a CPU, a GPU, and an NPU. A logic die LD2 of the second HBM HBM2 may include a memory controller MC2, an interface circuit IF2, and an interface logic OL2, and for example, the interface logic OL2 may include semiconductor chips or a universal chiplet interconnect express (UCIe) module configured to support an interface protocol between semiconductor dies. For example, interface circuits IF1 and IF2 may include a TSV repair logic and TSV macros illustrated in FIGS. 1 to 23, and the TSV repair logic may perform a TSV macro repair operation and a TSV repair operation.

The first and second HBMs HBM1 and HBM2 may be used for various-purpose data processing, and according to one or more example embodiments, the first and second HBMs HBM1 and HBM2 may be used in a neural network operation. For example, the first and second HBMs HBM1 and HBM2 may perform a neural network operation based on various kinds of models such as convolutional neural networks (CNN), recurrent neural networks (RNN), multi-layer perceptron (MLP), deep belief networks, and restricted Boltzmann machines.

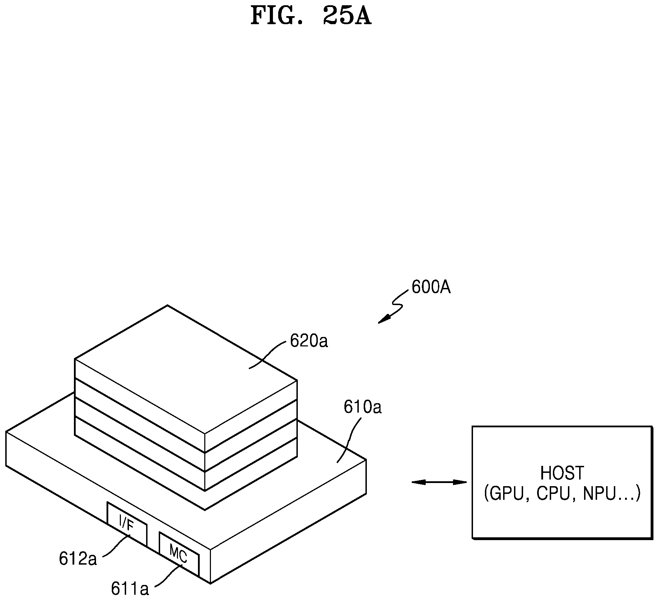

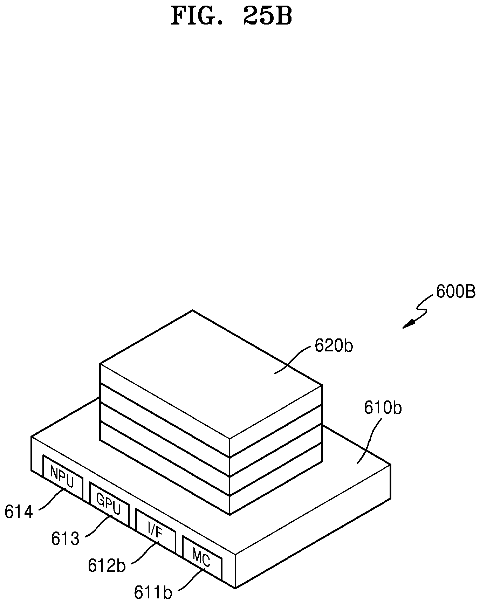

FIGS. 25A and 25B are diagrams illustrating an HBM semiconductor device according to example embodiments.

Referring to FIG. 25A, an HBM semiconductor device 600A may include a logic die 610a and HBM core dies or core dies 620a stacked on the logic die 610a. The logic die 610a may control a memory operation on the core dies 620a in response to a request from an external host. For example, the external host may include a CPU, a GPU, an NPU, an APU, and/or an AP. The logic die 610a may be electrically connected to a PCB through a plurality of bumps and/or connection terminals, and the HBM semiconductor device 600A may be implemented as a semiconductor package including a PCB. The logic die 610a may include a memory controller 611a and an interface circuit 612a, the interface circuit 612a may include TSV macros and a TSV repair logic each illustrated in FIGS. 1 to 23, and the TSV repair logic may perform a TSV macro repair operation and/or a TSV repair operation.

Referring to FIG. 25B, an HBM semiconductor device 600B may include a logic die 610b and HBM core dies or core dies 620b stacked on the logic die 610b. The logic die 610b may perform a function of a host, and thus, may control a memory operation on the core dies 620a. In detail, the logic die 610b may include a memory controller 611b and an interface circuit 612b, the interface circuit 612b may include TSV macros and a TSV repair logic each illustrated in FIGS. 1 to 23, and the TSV repair logic may perform a TSV macro repair operation and/or a TSV repair operation. Also, the logic die 610b may include various processing devices such as a GPU 613 and an NPU 614, based on performing a function of a host.

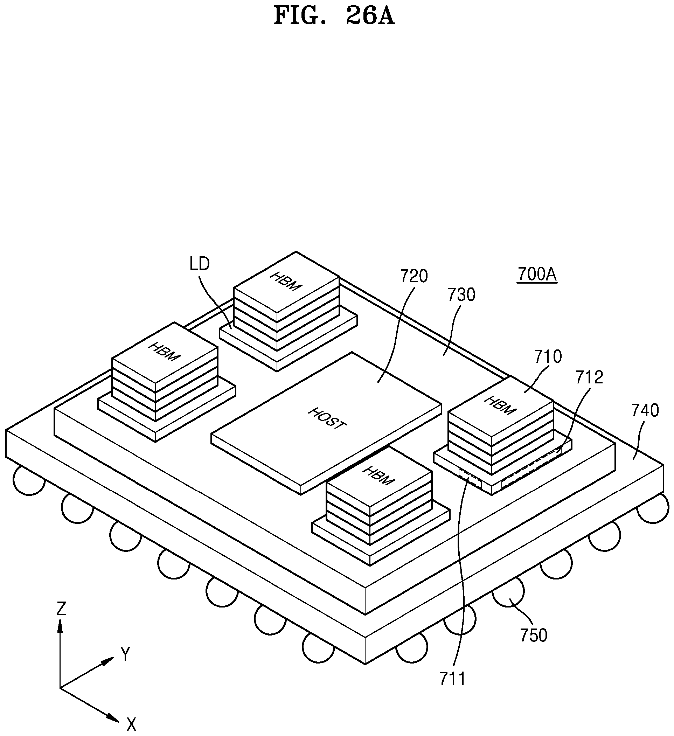

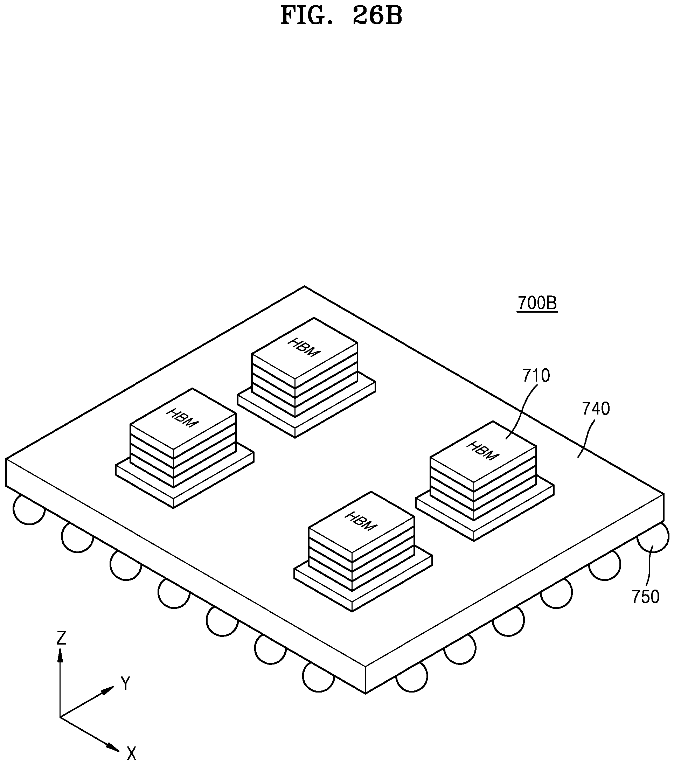

FIGS. 26A and 26B are diagrams illustrating an electronic system including an HBM semiconductor device according to one or more example embodiments.

Referring to FIG. 26A, an electronic system 700A may include one or more HBMs 710 according to one or more embodiments and a host 720. The HBMs 710 and the host 720 may be mounted on an interposer 730, and the interposer on which the HBMs 710 and the host 720 are mounted may be mounted on a package substrate 740. The host 720 may correspond to various semiconductor devices which request a memory access.

The HBM 710 may be implemented as a semiconductor device according to the one or more embodiments described above and may thus include a logic die LD and core dies stacked thereon, and according to one or more embodiments, the logic die LD may include an interface circuit 711 and a memory controller 712, and the interface circuit 711 may include a plurality of TSV macros respectively connected to a plurality of TSVs in a TSV region. The interface circuit 711 may be implemented according to the one or more embodiments described above with reference to FIGS. 1 to 23, and each TSV macro may process a signal and/or data transmitted and received between the logic die LD and the core dies through a corresponding TSV to support interfacing between the core dies and a memory controller through the corresponding TSV.

Furthermore, in a case where the HBM 710 includes a direct access (DA) region, a test signal may be provided to the HBM 710 through the DA region and a conductive means (for example, a solder ball 750) mounted under the package substrate 740. The interposer 730 may be implemented as various types such as, for example, a non-TSV or organic-based embedded multi-die interconnect bridge (EMIB) of a PCB type or a TSV type.

Referring to FIG. 26B, an electronic system 700B may include one or more HBMs 710 according to one or more embodiments. The HBMs 710 may be mounted on a package substrate 740. For example, each of the HBMs 710 may perform a function of a host. For example, each HBM 710 may be implemented like the HBM semiconductor device 600B of FIG. 25B. A logic die included in each HBM 710 may be implemented according to the one or more embodiments described above with reference to FIGS. 1 to 23, and each TSV macro may process a signal and/or data transmitted and received between a memory controller and a memory die through a corresponding TSV to support interfacing between core dies and the memory controller through the corresponding TSV.

At least one of the components, elements, modules or units described herein may be embodied as various numbers of hardware, software and/or firmware structures that execute respective functions described above and may include circuitry, a processor, a microprocessor, according to one or more example embodiments. For example, at least one of these components, elements or units may use a direct circuit structure, such as a memory, a processor, a logic circuit, a look-up table, etc. that may execute the respective functions through controls of one or more microprocessors or other control apparatuses. Also, at least one of these components, elements or units may be specifically embodied by a module, a program, or a part of code, which contains one or more executable instructions for performing specified logic functions, and executed by one or more microprocessors or other control apparatuses. Also, at least one of these components, elements or units may further include or implemented by a processor such as a central processing unit (CPU) that performs the respective functions, a microprocessor, or the like. Two or more of these components, elements or units may be combined into one single component, element or unit which performs all operations or functions of the combined two or more components, elements of units. Also, at least part of functions of at least one of these components, elements or units may be performed by another of these components, element or units. Further, although a bus is not illustrated in the above block diagrams, communication between the components, elements or units may be performed through the bus. Functional aspects of the above example embodiments may be implemented in algorithms that execute on one or more processors. Furthermore, the components, elements or units represented by a block or processing steps may employ any number of related art techniques for electronics configuration, signal processing and/or control, data processing and the like.

Hereinabove, example embodiments have been described in the drawings and the specification. Example embodiments have been described by using the terms described herein, but this has been merely used for describing the disclosure and has not been used for limiting a meaning or limiting the scope of the disclosure defined in the following claims. Therefore, it may be understood by those of ordinary skill in the art that various modifications and other equivalent embodiments may be implemented from the disclosure. Accordingly, the scope of the disclosure may be defined based on the scope of the following claims and their equivalents.

While the disclosure has been particularly shown and described with reference to example embodiments thereof, it will be understood that various changes in form and details may be made therein without departing from the scope of the following claims and their equivalents.

## Claims

1. A semiconductor device comprising:
a logic die comprising a memory controller and an interface circuit;
a plurality of core dies stacked in a vertical direction on the logic die, each of the plurality of core dies comprising a memory cell array; and
a plurality of through silicon vias, hereinafter referred to as TSVs, configured to electrically connect the logic die to the plurality of core dies, the plurality of TSVs comprising a plurality of operation TSVs and at least one redundancy TSV,
wherein the interface circuit comprises:
a plurality of TSV circuit blocks provided in a TSV region of the logic die and electrically connected to the plurality of TSVs, respectively; and
a TSV repair logic configured to perform a repair operation on a first TSV in which a defect occurs, among the plurality of operation TSVs, and a first TSV circuit block electrically connected to the first TSV, among the plurality of TSV circuit blocks.

2. The semiconductor device of claim 1, wherein the TSV repair logic is configured to change a transmission path of a first signal corresponding to the first TSV, in response to a first control signal indicating a defect of the first TSV.

3. The semiconductor device of claim 2, wherein the TSV repair logic is configured to:
change a TSV, through which the first signal is to be transmitted, from the first TSV to a second TSV; and
change a TSV circuit block, through which the first signal is to be transmitted, from the first TSV circuit block to a second TSV circuit block.

4. The semiconductor device of claim 3, wherein the second TSV comprises the at least one redundancy TSV or an operation TSV adjacent to the first TSV among the plurality of operation TSVs, and
wherein the second TSV circuit block comprises at least one redundancy TSV circuit block electrically connected to the at least one redundancy TSV or a TSV circuit block adjacent to the first TSV circuit block among the plurality of TSV circuit blocks.

5. The semiconductor device of claim 3 or claim 4, wherein the second TSV circuit block is configured to synchronize the first signal with a corresponding memory clock in response to a second control signal.

6. The semiconductor device of claim 5, wherein the first signal comprises at least one of a column address, a row address, and a clock signal.

7. The semiconductor device of any of claims 2-4, wherein the first signal comprises at least one of data, a column address, a row address, and a clock signal.

8. The semiconductor device of any preceding claim, wherein each of the plurality of TSV circuit blocks is configured to shift a voltage level of a signal transmitted through at least one corresponding TSV of the plurality of TSVs.

9. The semiconductor device of any preceding claim, wherein each of the plurality of TSV circuit blocks is configured to synchronize a signal, received from the plurality of core dies through at least one corresponding TSV of the plurality of TSVs, with a controller clock, or synchronize a signal, received from the memory controller through the at least one corresponding TSV, with a memory clock.

10. The semiconductor device of any preceding claim, wherein the plurality of TSV circuit blocks comprise a plurality of TSV macros each implemented as a hard macro, and
wherein the interface circuit comprises a TSV macro array comprising the plurality of TSV macros arranged in an array form.

11. The semiconductor device of any preceding claim, wherein each of the plurality of TSV circuit blocks comprises at least one of a receiver configured to receive a signal from the plurality of core dies through at least one corresponding TSV of the plurality of TSVs and a transmitter configured to transmit a signal to the plurality of core dies through the at least one corresponding TSV.

12. The semiconductor device of any preceding claim, wherein the plurality of TSVs are provided in the TSV region of the logic die.

13. The semiconductor device of any preceding claim, wherein the semiconductor device comprises a high bandwidth memory.

14. The semiconductor device of any preceding claim, wherein the logic die further comprises an interface logic or at least one of a central processing unit, a graphics processing unit, a neural processing unit, an accelerated processing unit, and an application specific integrated circuit.

15. A logic die comprising:
a memory controller;
a plurality of through silicon vias (TSVs) comprising a plurality of operation TSVs and at least one redundancy TSV, the plurality of TSVs being provided in a TSV region; and
an interface circuit between the memory controller and the plurality of TSVs,
wherein the interface circuit comprises:
a plurality of TSV macros arranged in an array form in the TSV region and electrically connected to the plurality of TSVs, respectively; and
a TSV repair logic configured to perform a repair operation on a first TSV, in which a defect occurs, among the plurality of operation TSVs and a first TSV macro, electrically connected to the first TSV, among the plurality of TSV macros.
